# EUROPEAN PATENT APPLICATION

(11) **EP 2 228 754 A1**
(43) Date of publication of application: **15.09.2010**
(21) Application number: 07850377.8
(22) Date of filing: 10.12.2007
(51) Int. Cl.: G06K 17/00, H01R 12/18, H01R 31/06

(54) **SIM ADAPTER AND SIM CARD**

(71) Applicant: Renesas Electronics Corporation, Nakahara-ku Kawasaki Kanagawa 211-8668 (JP)
(72) Inventor: NISHIZAWA, Hirotaka, Kanagawa 211-8668 (JP); KOIKE, Hideo, Kanagawa 211-8668 (JP); OSAKO, Junichiro, Kanagawa 211-8668 (JP); WADA, Tamaki, Kanagawa 211-8668 (JP); TOTSUKA, Takashi, Kanagawa 211-8668 (JP)
(74) Representative: Calderbank, Thomas Roger
(86) International application number: PCT/JP2007/073811
(87) International publication number: WO 2009/075023

(57) **Abstract**

In an IC card, there is provided a technique capable of large expandability of a memory volume, and a memory volume and a cost matched with a user's requirement. A SIM adapter 101 has a top panel 104 for covering a recess portion. In the top panel 104, when a memory card 103 is not inserted, the top panel 104 is positioned at a first height, and, when the memory card 103 is inserted, a part of the top panel 104 is engaged with a part of the SIM adapter 101 so that the top panel is latched at a second height higher than the first height. Also, into a SIM adapter, a top panel for fixing a memory card when the memory card is inserted is inserted, and a part of the top panel is engaged with a part of the SIM adapter so that the top panel is latched when the memory card is inserted. Further, into a SIM adapter, a top panel for fixing a memory card when the memory card is inserted is inserted, and the top panel has a terminal strip contacting with both of a terminal of the SIM adapter and a terminal of the memory card so that the terminal strip electrically connects between both of them.

## Description

### TECHNICAL FIELD

The present invention relates to a SIM adapter and a SIM card, and more particularly, the present invention relates to a SIM adapter and a SIM card for an IC card in which a removable thin memory card is attached and which is focused on compatibility.

### BACKGROUND ART

As techniques studied by the inventors, for example, the following techniques are considered in an IC card.

For example, one type of the IC card is a so-called SIM card (Subscriber Identity Module Card). The SIM card is an IC card which is inserted into a mobile phone for user identification and in which subscriber information is recorded. By using a common IC card as inserting into a mobile phone even with a different system from an original one, phone number and charging information can be directly carried to the mobile phone for use, and the IC card has been achieved as a GSM card in a GSM mobile phone. For an outline dimension of a SIM card, ID-000 format of 15 mm x 25 mm x 0.76 mm is used. That is, a planar dimension of the same is 15 mm x 25 mm, and a thickness of the same is about 0.76 mm. On a surface of the same, there is provided an external interface terminal (IS07816 interface terminal) determined by standards of a terminal position and a functionality in conformity with ISO/IEC7816-3. Note that a technique disclosed in, for example, Patent Document 1 or others is cited as a technique relating to such an IC card.

The Patent Document 1 discloses an IC card module having a microcomputer, a memory card controller, and a flash memory. The IC card module, in which a plurality of first external connection terminals and a plurality of second external connection terminals are exposed on one surface of a card board, has a microcomputer connected with the first external connection terminals, a memory card controller connected with the second external connection terminals, and a flash memory connected with the memory card controller. A shape of the card board and an arrangement of the first external connection terminals are in conformity with the standard of the plug-in UICC (Universal Integrated Circuit Card) in the ETSI TS 102 221 V4.4.0 (2001-10), or are compatible with the same. The second external connection terminals are arranged outside a minimum area of the terminal arrangement which is in conformity with the standard of the first external connection terminals, and signal terminals of the first external connection terminals and the second external connection terminals are electrically isolated from each other. In this manner, the compatibility of the IC card module with a SIM card and high-speed memory access of the same can be achieved.

Also, Non-Patent Document 1 discloses a technique relating to a general smart card.

Patent Document 1: Japanese Patent Application Laid-Open Publication No. 2005-322109

Non-Patent Document 1: "Smart Card Handbook" published by W. Raukl & W. Effing, Vol.2, WILEY, P.27 to 31

### DISCLOSURE OF THE INVENTION

### PROBLEMS TO BE SOLVED BY THE INVENTION

Incidentally, the inventors have studied on the technique for the IC card as described above, and as a result, the followings have been found out.

For example, while a nonvolatile memory such as an EEPROM is mounted on a secure IC (SIC), its memory volume becomes insufficient depending on how to use it. For expanding the memory volume, it is considered that a flash memory is mounted as an expansion memory as described in Patent Document 1. However, it costs much to mount a flash memory with a uniformly-fixed memory volume for all users. As a nonvolatile expansion memory such as a flash memory, it is desirable that, expandability of the memory volume is large, and the memory volume and the cost are matched with a user's requirement.

Also, it is desirable to enhance security functionality in a memory region, enhance a falsification-preventing functionality, and achieve portability into a different-shaped IC card.

Accordingly, a preferred aim of the present invention is, in an IC card, to provide a technique capable of the large expandability of the memory volume, the memory volume and the cost matched with a user's requirement, the securement of the memory security, and the expanded portability into a different IC card or host.

Also, another preferred aim of the present invention is, in an IC card, to provide a technique also capable of functionality expansion except for the memory functionality as matching with a user's requirement.

The above and other preferred aims and novel characteristics of the present invention will be apparent from the description of the present specification and the accompanying drawings.

### MEANS FOR SOLVING THE PROBLEMS

Among many embodiments disclosed in the preset application, the typical one will be briefly described as follows.

That is, a SIM adapter according to a typical embodiment on which a secure IC chip having a security microcomputer functionality is mounted has a recess portion to which a memory card is inserted. This SIM adapter has a top panel for covering the recess portion, and the top panel is positioned at a first height when the memory card is not inserted. When the memory card is inserted, a part of the top panel is engaged with a part of the SIM adapter, so that the top panel is latched at a second height higher than the first height.

Also, a top panel for fixing a memory card when the memory card is inserted is inserted into a SIM adapter according to another embodiment, and, when the memory card is inserted, a part of the top panel is engaged with a part of the SIM adapter so that the top panel is latched.

Further, a top panel for fixing a memory card when the memory card is inserted is inserted into a SIM adapter according to still another embodiment, and the top panel has a terminal strip contacting with both of a terminal of the SIM adapter and a terminal of the memory card when the memory card is inserted so that the terminal strip electrically connects between the SIM adapter and the memory card.

Still further, into a recess portion of a SIM adapter according to still another embodiment, a card having a NFC (abbreviation of Near Field Communication) functionality is inserted.

### EFFECTS OF THE INVENTION

Among many embodiments disclosed in the preset application, the effects obtained by the above-described typical one of the present invention will be briefly described below.

In an IC card, a large expandability of a memory volume, and a memory volume and a cost matched with a user's requirement are possible.

Among many embodiments disclosed in the preset application, the effects obtained by another embodiment of the above-described typical one of the present invention will be briefly described below.

In an IC card, expansion of a NFC functionality or others matched with a user's requirement is possible.

### BRIEF DESCRIPTIPNS OF THE DRAWINGS

FIGs. 1A to 1E are views illustrating outlines of a SIM adapter according to a first embodiment of the present invention, FIG. 1A is a bottom view, FIG. 1B is a plan view, FIG. 1C is a right side view, FIG. 1D is a front view, and FIG. 1E is a cross-sectional view in a cutting surface taken along line a-a';
FIGs. 2A to 2E are views illustrating outlines of the SIM adapter according to the first embodiment of the present invention, FIG. 2A is a bottom view, FIG. 2B is a plan view, FIG. 2C is a right side view, FIG. 2D is a front view, and FIG. 2E is a cross-sectional view in a cutting surface taken along line a-a';
FIGs. 3A to 3E are views illustrating outlines of a SIM adapter according to a second embodiment of the present invention, FIG. 3A is a bottom view, FIG. 3B is a plan view, FIG. 3C is a right side view, FIG. 3D is a front view, and FIG. 3E is a cross-sectional view in a cutting surface taken along line a-a';
FIGs. 4A to 4E are views illustrating outlines of the SIM adapter according to the second embodiment of the present invention, FIG. 4A is a bottom view, FIG. 4B is a plan view, FIG. 4C is a right side view, FIG. 4D is a front view, and FIG. 4E is a cross-sectional view in a cutting surface taken along line a-a';
FIGs. 5A to 5E are views illustrating outlines of a SIM adapter according to a third embodiment of the present invention, FIG. 5A is a perspective view of a top panel, FIG. 5B is a perspective view of the SIM adapter, FIG. 5C is a perspective view of a memory card, FIG. 5D is a cross-sectional view in a cutting surface taken along line a-a' before the memory card is inserted, and 5E is a cross-sectional view in the cutting surface taken along line a-a' after the memory card is inserted;
FIGs. 6A to 6D are views illustrating outlines of a SIM adapter according to a fourth embodiment of the present invention, FIG. 6A is a perspective view of the SIM adapter, FIGs. 6B and 6C are cross-sectional views in a cutting surface taken along line a-a' before a memory card is inserted, and 6D is a cross-sectional view in the cutting surface taken along line a-a' after the memory card is inserted;
FIGs. 7A to 7D are views illustrating outlines of a SIM adapter according to a fifth embodiment of the present invention, FIG. 7A is a bottom view, FIG. 7B is a plan view, FIG. 7C is a right side view, and FIG. 7D is a front view;
FIG. 8 is views illustrating a state before a memory card and a top panel are inserted into the SIM adapter according to the fifth embodiment of the present invention;
FIG. 9 is views illustrating another state before the memory card and the top panel are inserted into the SIM adapter according to the fifth embodiment of the present invention;
FIG. 10 is, in the fifth embodiment of the present invention, a view illustrating a state after the memory card and the top panel are inserted into the SIM adapter;
FIGs. 11A to 11D are views illustrating outlines of the SIM adapter according to the fifth embodiment of the present invention, FIG. 11A is a bottom view, FIG. 11B is a plan view, FIG. 11C is a right side view, and FIG. 11D is a front view;
FIG. 12 is, in the fifth embodiment of the present invention, a view illustrating a state before the top panel is inserted into the SIM adapter;
FIG. 13 is, in the fifth embodiment of the present invention, a view illustrating a state after the top panel is inserted into the SIM adapter;
FIGs. 14A to 14C are perspective views illustrating outlines of a SIM adapter and a top panel according to a sixth embodiment of the present invention, FIG. 14A illustrates the SIM adapter, and FIGs. 14B and 14C illustrate the top panel on which an insulating sheet for preventing short circuit is adhered;
FIGs. 15A to 15C are perspective views illustrating outlines of a SIM adapter and a top panel according to a seventh embodiment of the present invention, FIG. 15A illustrates the SIM adapter, FIG. 15B illustrates a high top panel for inserting a memory card, and 15C illustrates a low top panel;
FIGs. 16A and 16B are perspective views illustrating outlines of a SIM adapter and a top panel according to an eighth embodiment of the present invention, FIG. 16A illustrates a state before the top panel is inserted into the SIM adapter, and FIG. 16B illustrates a state after the top panel is inserted into the SIM adapter;
FIGs. 17A to 17C are perspective views illustrating outlines of a SIM adapter and a blank card according to a ninth embodiment of the present invention, FIG. 17A illustrates a view from a front side of the blank card, FIG. 17B illustrates a view from a rear side of the blank card, and FIG. 17C illustrates the SIM adapter;
FIG. 18 is views illustrating outlines of a memory card and a top panel in a state before they are inserted into a SIM adapter according to a tenth embodiment of the present invention;
FIGs. 19A to 19C are views illustrating a structure of a terminal strip of a SIM adapter according to an eleventh embodiment of the present invention;
FIGs. 20A to 20D are views illustrating a structure of a top panel according to a twelfth embodiment of the present invention, FIG. 20A is a plan view, FIG. 20B is a side view, FIG. 20C is a front view, and FIG. 20D is a cross-sectional view in a cutting surface taken along line a-a';
FIGs. 21A to 21C are views illustrating a structure of a top panel according to a thirteenth embodiment of the present invention, FIG. 21A is a plan view, FIG. 21B is a side view, and FIG. 21C is a front view;
FIGs. 22A to 22C are views illustrating a structure of a top panel according to a fourteenth embodiment of the present invention, FIG. 22A is a plan view, FIG. 22B is a side view, and FIG. 22C is a front view;
FIGs. 23A to 23E are views illustrating a structure of a top panel according to a fifteenth embodiment of the present invention, FIG. 23A is a bottom view, FIG. 23B is a plan view, FIG. 23C is a side view, FIG. 23D is a front view, and FIG. 23E is a cross-sectional view in a cutting surface taken along line a-a';
FIGs. 24A and 24B are views illustrating structures of the top panel and the SIM adapter according to the fifteenth embodiment of the present invention, FIG. 24A is a plan view, and FIG. 24B is a cross-sectional view in a cutting surface taken along line a-a';
FIGs. 25A to 25E are views illustrating a structure of a top panel according to a sixteenth embodiment of the present invention, FIG. 25A is a bottom view, FIG. 25B is a plan view, FIG. 25C is a side view, FIG. 25D is a front view, and FIG. 25E is a cross-sectional view in a cutting surface taken along line a-a';
FIGs. 26A and 26B are views illustrating structures of the top panel and a SIM adapter according to the sixteenth embodiment of the present invention, FIG. 26A is a plan view, and FIG. 26B is a cross-sectional view in a cutting surface taken along line a-a';
FIGs. 27A to 27E are views illustrating a structure of a top panel according to a seventeenth embodiment of the present invention, FIG. 27A is a bottom view, FIG. 27B is a plan view, FIG. 27C is a side view, FIG. 27D is a front view, and FIG. 27E is a cross-sectional view in a cutting surface taken along line a-a';
FIGs. 28A and 28B are views illustrating structures of the top panel and a SIM adapter according to the seventeenth embodiment of the present invention, FIG. 28A is a plan view, and FIG. 28B is a cross-sectional view in a cutting surface taken along line a-a';
FIGs. 29A to 29E are views illustrating a structure of a top panel according to an eighteenth embodiment of the present invention, FIG. 29A is a bottom view, FIG. 29B is a plan view, FIG. 29C is a side view, FIG. 29D is a front view, and FIG. 29E is a cross-sectional view in a cutting surface taken along line a-a';
FIGs. 30A and 30B are views illustrating structures of the top panel and a SIM adapter according to the eighteenth embodiment of the present invention, FIG. 30A is a plan view, and FIG. 30B is a cross-sectional view in a cutting surface taken along line a-a';
FIG. 31 is a block diagram illustrating a configuration of a mobile terminal studied as a precondition of the present invention;
FIG. 32 is a diagram illustrating an example of a terminal arrangement (ISO7816 terminals) on a rear surface of a SIM card illustrated in FIG. 31;
FIG. 33 is a block diagram illustrating a configuration of a mobile terminal according to a nineteenth embodiment of the present invention;
FIG. 34 is a diagram illustrating an example of a terminal arrangement (ISO7816 terminals and SWP terminal) on a rear surface of a SIM adapter illustrated in FIG. 33;
FIG. 35 is a block diagram illustrating a configuration of a mobile terminal according to a twentieth embodiment of the present invention;
FIG. 36 is a diagram illustrating an example of a terminal arrangement (ISO7816 terminals and antenna terminal) on a rear surface of a SIM adapter illustrated in FIG. 35;
FIGs. 37A and 37B are views illustrating an outline of a SIM adapter according to a twenty-first embodiment of the present invention, FIG. 37A illustrates a state before an expansion card is inserted into the SIM adapter, and FIG. 37B illustrates a state that the expansion card is attached in a top panel;
FIG. 38 is a diagram illustrating a terminal assignment in a SIM card studied as a precondition of the present invention;
FIGs. 39A and 39B are a block diagram illustrating a configuration of an IC card studied as a precondition of the present invention and a block diagram illustrating a configuration of the IC card according to the first embodiment of the present invention, respectively;
FIGs. 40A and 40B are vertical-cross-sectional views illustrating a configuration of the SIM adapter according to the first embodiment of the present invention;
FIGs. 41A to 41E are views illustrating outlines of the SIM adapter according to the first embodiment of the present invention, FIG. 41A is a perspective view of the top panel, FIG. 41B is a perspective view of the SIM adapter, FIG. 41C is a perspective view of the memory card, FIG. 41D is a cross-sectional view in a cutting surface taken along line a-a' before the memory card is inserted, and FIG. 41E is a cross-sectional view in the cutting surface taken along line a-a' after the memory card is inserted; and
FIG. 42 is a diagram illustrating an example of a wire connection of the SIM adapter according to the first embodiment of the present invention.

### BEST MODE FOR CARRYING OUT THE INVENTION

Hereinafter, embodiments of the present invention will be described in detail with reference to the accompanying drawings. Note that components having the same function are denoted by the same reference symbols throughout the drawings for describing the embodiment, and the repetitive description thereof will be omitted.

### (First Embodiment)

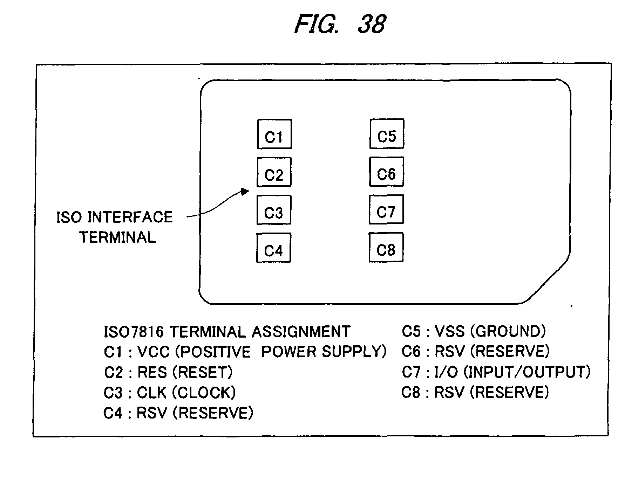

FIG. 38 is a diagram illustrating a terminal assignment in a SIM card studied as a precondition of the present invention.

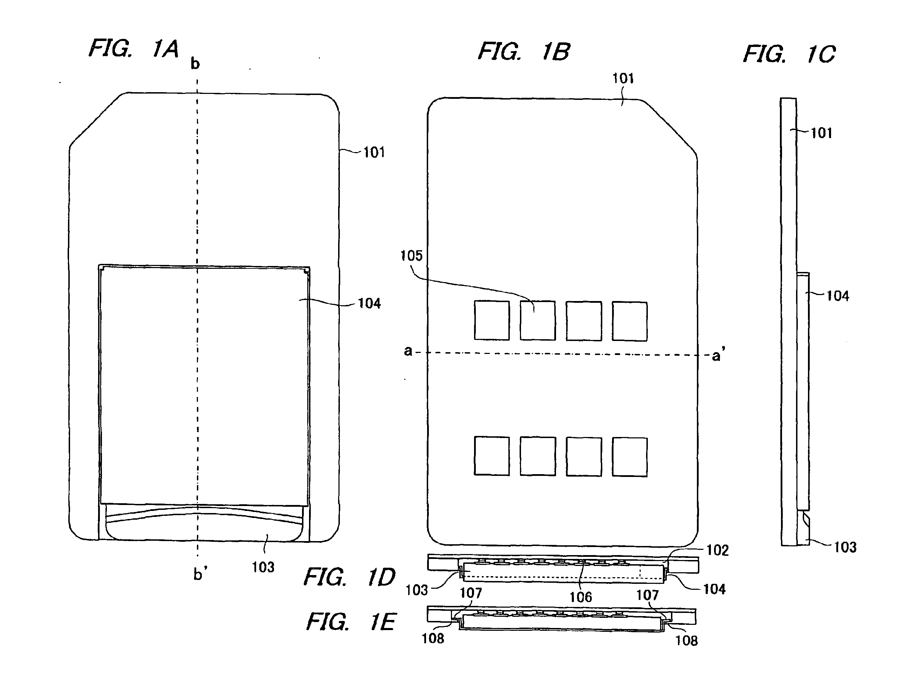

As illustrated in FIG. 38, eight terminals of C1 to C8 as ISO7816 interface terminals are generally arranged on a SIM card, and the ISO7816 terminals are assigned such that C1 is assigned for VCC (positive power supply), C2 is assigned for RES (reset), C3 is assigned for CLK (clock), C4, C6, and C8 are assigned for RSVs (reserve), C5 is assigned for VSS (ground), and C7 is assigned for I/O (input/output). Here, the reserve terminals can be used as an expansion terminal for achieving a USB interface, achieving an MMC and a serial interface, achieving a non-contact (contactless card) functionality, or others. Note that the same terminals are provided on a SIM adapter 101 of the present invention illustrated in FIG. 1 and others.

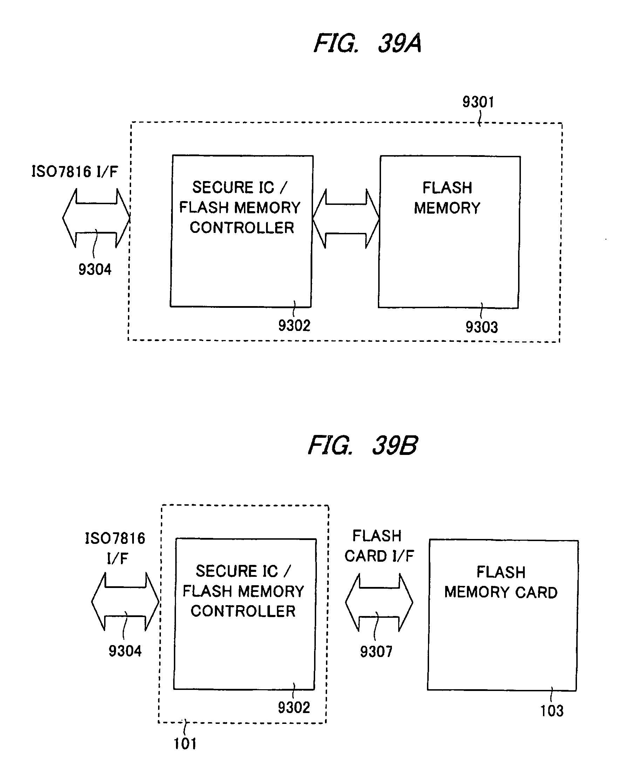

FIG. 39A is a block diagram illustrating a configuration of an IC card studied as a precondition of the present invention.

The IC card illustrated in FIG. 39A is a conventional integrated SIM memory 9301 in the above-described Patent Document 1. This SIM memory 9301 is configured with an IC chip on which a secure IC/flash memory controller 9302 is mounted and an IC chip of a flash memory 9303. Also, the SIM memory 9301 has an ISO7816 I/F (interface) through the ISO7816 interface terminals C1 to C8 in conformity with the standards of ISO/IEC7816-3, and is connected with an external device.

FIG. 39B is a block diagram illustrating a configuration of an IC card according to the first embodiment of the present invention.

The IC card illustrated in FIG. 39B is a SIM adapter 101 including the IC chip of the secure IC/flash memory controller 9302. Similarly to the conventional integrated SIM memory 9301 described above, the SIM adapter 101 has an ISO7816 I/F 9304 through the ISO7816 interface terminals C1 to C8 in conformity with the standards of ISO/IEC7816-3, and can be connected with an external device. Also, the SIM adapter 101 can be connected with a flash memory card 103 including a flash memory with using a flash card I/F 307 through a connector terminal for electrically connecting signals to a slot for holding the card. That is, the flash memory is included in the flash memory card 103, and the flash memory card 103 can be physically disconnected with the SIM card and can be connected and disconnected by the SIM adapter 101. The IS07816 I/F 9304 and the flash card I/F 9307 can be also in conformity with a smart card I/F.

Also, the flash card I/F can be also used as an existing memory card I/F.

A feature of the IC card according to the first embodiment illustrated in FIG. 39B is as follows.

The flash memory card 103 and the SIM adapter 101 can be physically disconnected with each other. That is, they can be repeatedly disconnected and connected with each other through the connector system. In other words, the flash memory card 103 and the SIM adapter 101 are removable from each other.

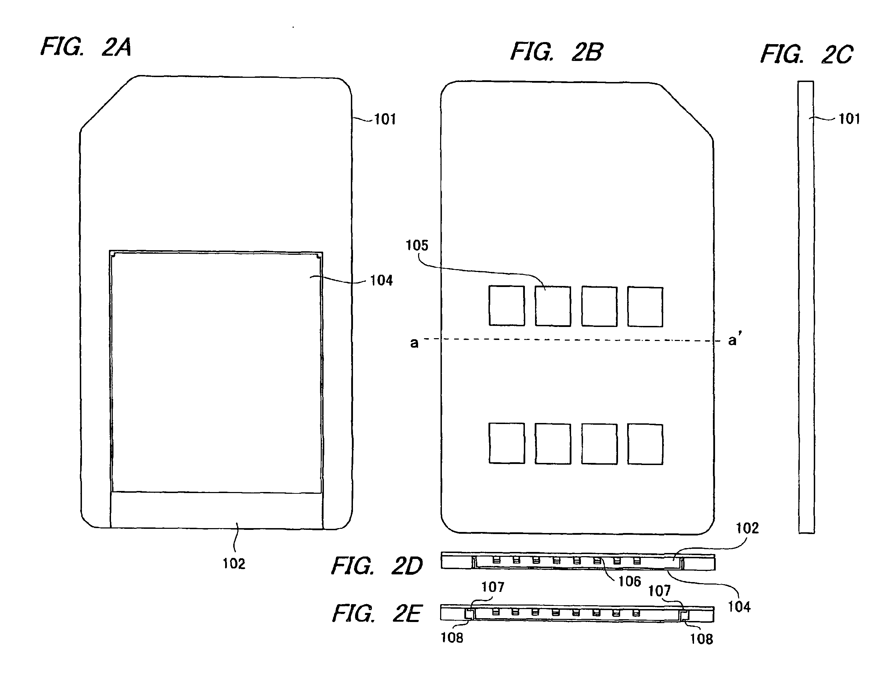

FIGs. 1A to 1E and 2A to 2E are views illustrating outlines of the SIM adapter according to the first embodiment of the present invention, FIGs. 1A and 2A are bottom views, FIGs. 1B and 2B are plan views, FIGs. 1C and 2C are right side views, FIGs. 1D and 2D are front views, and FIGs. 1E and 2E are cross-sectional views in a cutting surface taken along line a-a'. FIGs. 1A to 1E illustrate views in a state that the memory card (flash memory card) 103 such as a microSD (trademark) is inserted into a card slot (recess portion) 102 in the SIM adapter 101, and FIGs. 2A to 2E illustrate views in a state that the memory card 103 is not inserted.

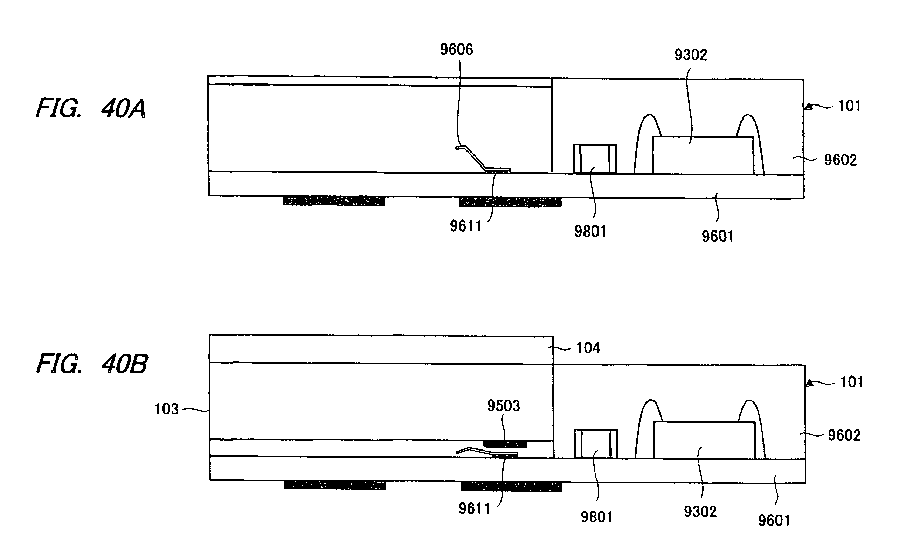

FIGs. 40A and 40B are cross-sectional views illustrating a detailed cross-sectional view taken along line b-b' in the SIM adapter 101 in FIG. 1A. FIG. 40A is a view before the memory card 103 is inserted, and FIG. 40B is a view after the memory card 103 is inserted.

On a board 9601 such as a wiring layer and a wiring board, there are provided: a module region 9602 on which the IC chip such as the secure IC/flash memory controller 9302 and an IC-chip unit 9801 such as a passive element and an active element such as a capacitor and a resistor are mounted; and a connector terminal 9606 adhered by soldering or welding. In FIGs. 40A and 40B, a solder 9611 is illustrated. The connector terminal 9606 is provided between the module region 9602 on a front-surface side of the SIM adapter 101 and an insertion-opening side from which the memory card is inserted to be an opposite side to the module region.

As illustrated in FIG. 40B, after the memory card 103 is inserted into the SIM adapter 101, the connector terminal 9606 on the SIM adapter 101 is contacted with a connector terminal 9503 on the flash memory card 103, and the connector terminal 9606 is bent toward the board 9601 side, so that electrical-connection certainty is secured.

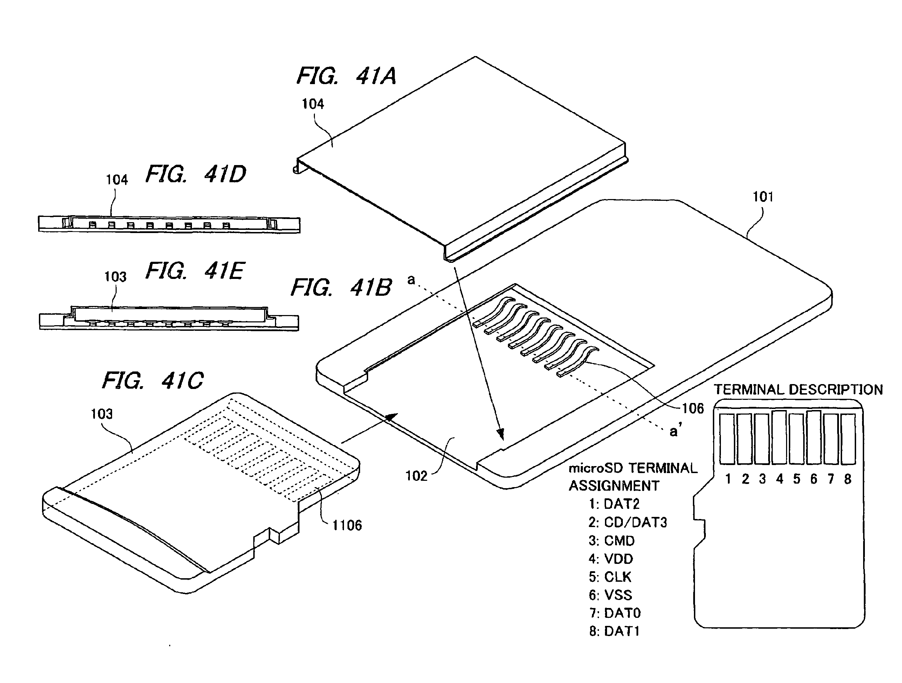

FIGs. 41A to 41E illustrate outline views of a state before the memory card 103 is inserted into the SIM adapter 101.

The terminal 106 provided on the SIM adapter 101 and a terminal 1106 (illustrated by dashed lines because it is not apparent from a front surface of the card in FIG. 41) provided on a rear surface of the memory card 103 are connected with each other when the card is inserted.

Also, a bottom-right corner in FIG. 41 describes generally-known terminal names.

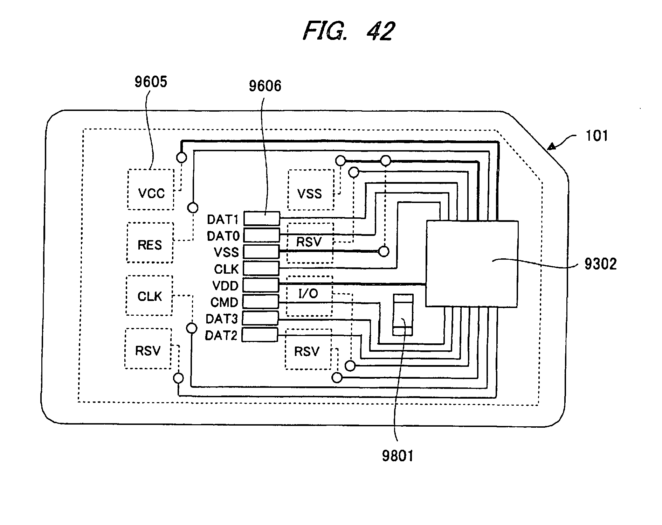

FIG. 42 is a diagram illustrating an example of a wire connection of the SIM adapter 101.

In the SIM adapter 101, the IC chip such as the secure IC/flash memory controller 9302 and the chip unit 9801 such as a passive element and an active element such as a capacitor, a resistor, and a coil are mounted. Note that the IC chip such as the secure IC/flash memory controller 9302 may be a single chip or plural chips. Also, these IC chip 9302 and chip unit 9801 are sealed by a seal resin, so that their shapes and strengths are secured.

The secure IC/flash memory controller does not necessarily have a secure microcomputer functionality, and only a controller for protocol conversion may be used. Also, when the secure IC functionality is installed in the memory card, only wire-connection conversion may be performed without any controller. That is, the secure IC/flash memory controller becomes a terminal conversion adapter.

In the SIM adapter 101, a plurality of ISO7816 electrodes 9605 for the ISO7816 I/F 9304 and a plurality of connector terminals 9606 for the flash card I/F 9307 are wire-connected with the IC chip such as the secure IC/flash memory controller 9302 and the chip unit 9801. Note that a wire of the chip unit 9801 is omitted.

Although a double-layer connection is exemplified in FIG. 42, a triple- or more-layer connection may be used. Also, the wire connection may be formed by a metal frame or a metal-wired lead frame generated by pressing. The metal-wired lead frame is formed by using an insulating resin, an insert-molding method, and others.

In the ISO7816 electrodes 9605, VCC denotes a VCC power supply terminal, RES denotes a reset terminal, CLK denotes a clock terminal, RSV denotes a reserve terminal, VSS denotes a ground terminal, and I/O denotes an input/output terminal. In the connector terminals 9606, CMD denotes a command terminal, DAT0 DAT1, DAT2, and DAT3 denote data input/output terminals, CLK denotes a clock terminal, VDD denotes a VDD power supply terminal, and VSS denotes a ground terminal, which are basically compatible with a microSD. Also, the reserve terminals can be used as a ETSI functionality-expansion terminal or others in accordance with a desired purpose.

Note that the mounting of the secure IC/flash memory controller 9302 can be connected by a wire-bonding method, a flip chip method, a method of embedding devices in a board, or others. Also, the mounting can be treated on an ISO pad with expansion terminals.

Further, it is desirable to secure electrical connection of a surface of the connector terminal 9605 by a metal-plating method or others.

As described above, the flash memory card 103 and the SIM adapter 101 can be physically disconnected with each other. That is, they can be repeatedly disconnected and connected with each other through the connector system. In other words, the flash memory card 103 and the SIM adapter 101 are removable from each other.

In this manner, increase and decrease of the memory volume matched with a user's requirement is possible.

Next, another feature of the present embodiment is described, the feature being a configuration that the memory card is thicker than the SIM adapter.

As illustrated in FIGs. 1A and 2A, a movable top panel 104 for covering the card slot 102 is provided on one surface of the SIM adapter according to the first embodiment. The top panel 104 has a convex shape. In FIG. 1E, the shape is apparently a reverse convex shape. The top panel 104 has a thickness of, for example, about 0.1 µm. Although the top panel 104 is preferably made of a metal in consideration of its thinness and strength, it may be made of other material such as a resin. Also, as illustrated in FIGs. 1B and 2B, an ISO7816 electrode 105 is provided on the other surface of the SIM adapter. Further, one of four corners of the SIM adapter is chamfered.

The top panel 104 is positioned at a first height as illustrated in FIGs. 2D and 2E when the memory card 103 is not inserted.

Here, the first height is almost the same as a height (thickness) of the SIM adapter 101. When the memory card 103 is inserted, as illustrated in FIGs. 1D and 1E, both ends (insertion-guiding portion 107) of the top panel 104 is engaged with a part (top-panel-holding portion 108) of the SIM adapter 101, so that the top panel 104 is latched at a second height higher than the first height. As illustrated in FIGs. 1A to 1E, when the memory card 103 is inserted into the card slot 102 which is an inserted space, the top panel 104 is pushed up by the thickness of the memory card 103, and the both ends (insertion-guiding portion 107) of the top panel 104 is engaged with a protruding portion (top-panel-holding portion 108) of the card slot, so that the top panel 104 and the memory card 103 are fixed to each other. Also, in the card slot 102 of the SIM adapter 101, a terminal strip 106 for electrically connecting between the SIM adapter 101 and the memory card 103 is arranged. The terminal strip 106 has a plate-like spring structure, and the memory card 103 is stably fixed by urging force of the structure. As illustrated in FIGs. 2A to 2E, when the memory card 103 is not inserted into the card slot 102, the top panel 104 is lowered inside, and one surface of the SIM adapter 101 is flattened, so that the shape of the SIM adapter 101 becomes the same as that of a conventional SIM card. Also, since the terminal strip 106 is not exposed because the top panel 104 exists, the terminal strip 106 is protected from damages due to contact in use.

An outline dimension of the SIM adapter 101 is, for example, 15 mm x 25 mm x 0.76 mm which is the same as the SIM card in conformity with the standard of plug-in UICC (Universal Integrated Circuit Card) in ETSI TS 102 221 V4.4.0 (2001-10). That is, a planar dimension of the SIM adapter is 15 mm x 25 mm, and a thickness of the same is about 0.76 mm. The thickness is allowed in a range of 0.76 mm ± 0.08 mm, and can be 0.84 mm or thinner. An outline dimension of the memory card 103 (microSD (trademark)) is smaller than that of the SIM adapter 101, and its thickness is about 1.0 mm thicker than 0.76 mm in the SIM adapter 101.

A secure IC chip having a security microcomputer is mounted on the SIM adapter 101. When the memory card 103 is not inserted into the SIM adapter 101, the SIM adapter 101 can be operated as a conventional SIM card.

In this manner, by providing the top panel movable up and down on the SIM adapter, the top panel can cover the memory card even when the memory card thicker than the SIM adapter is inserted.

Also, even when the memory card is not inserted, the terminal strip 106 on the SIM adapter can be protected by the top panel.

### (Second Embodiment)

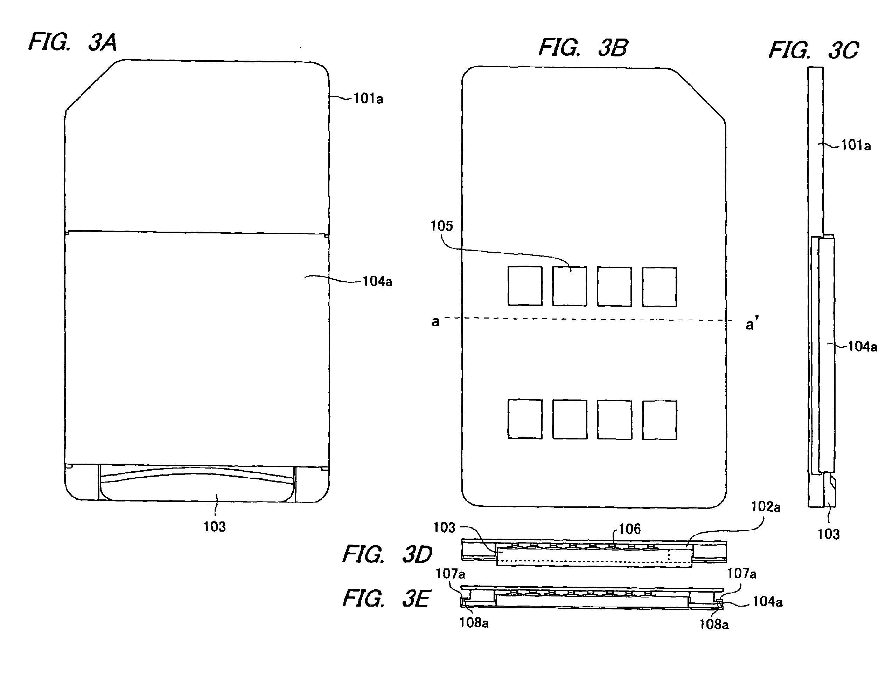

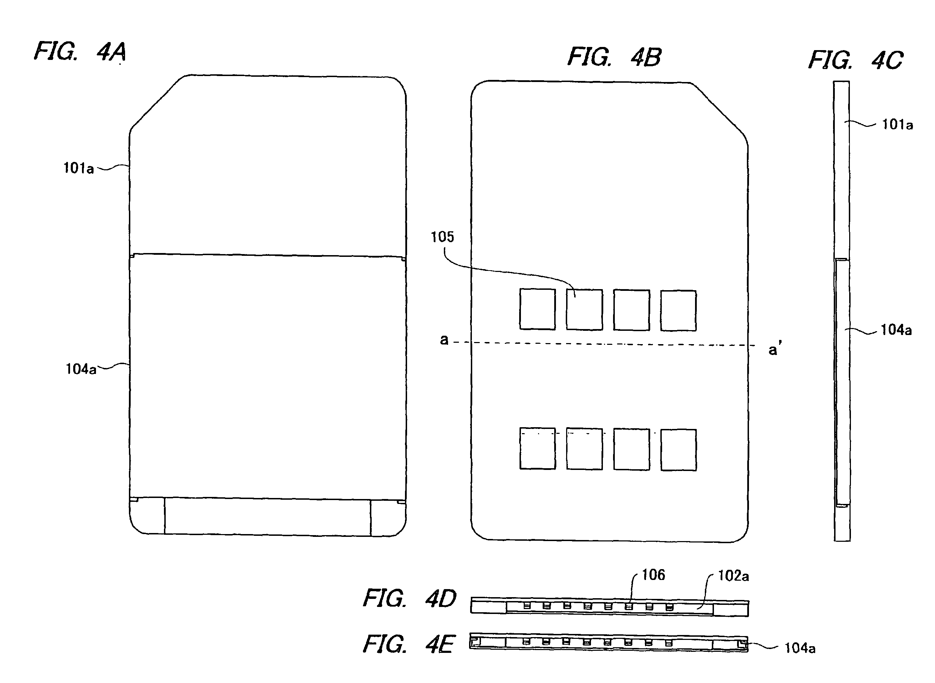

FIGs. 3A to 3E and 4A to 4E are views illustrating outlines of a SIM adapter according to a second embodiment of the present invention, FIGs. 3A and 4A are bottom views, FIGs. 3B and 4B are plan views, FIGs. 3C and 4C are right side views, FIGs. 3D and 4D are front views, and FIGs. 3E and 4E are cross-sectional views in a cutting surface taken along line a-a'. FIGs. 3A to 3E illustrate views in a state that a memory card 103 such as a microSD (trademark) is inserted into a card slot (recess portion) 102a in a SIM adapter 101a and FIGs. 4A to 4E illustrate views in a state that the memory card 103 is not inserted.

The SIM adapter 101a according to the second embodiment has a wider top panel 104a than that of the SIM adapter 101 according to the first embodiment. In the first embodiment, the protruding portion (top-panel-holding portion) is provided inside the card slot 102 so that the top panel 104 is latched by the top panel-holding portion. However, in the second embodiment, a protruding portion (top-panel-holding portion 108a) is provided outside the SIM adapter 101 so that an insertion-guiding portion 107a in the top panel 104a is latched by the top-panel-holding portion 108a. By such a structure, the same effects as those of the first embodiment can be obtained.

Further, in the second embodiment, the top panel covers a wider area of the SIM adapter than that in the first embodiment, and therefore, protective performance for the SIM adapter is increased.

Structures of other units are the same as those of the SIM adapter according to the first embodiment, and therefore, their descriptions are omitted.

### (Third Embodiment)

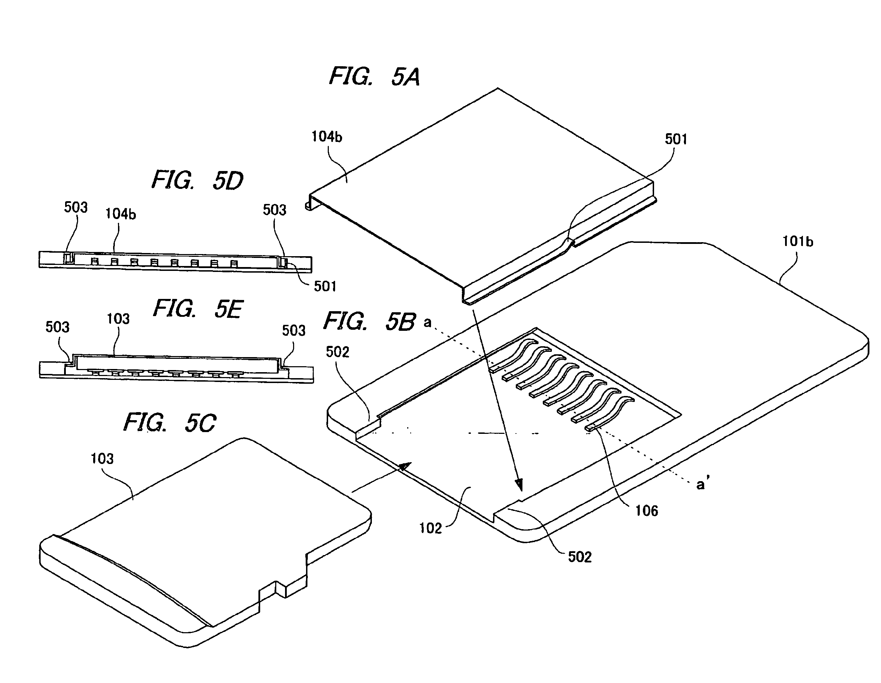

FIGs. 5A to 5E are views illustrating outlines of a SIM adapter according to a third embodiment of the present invention, FIG. 5A is a perspective view of a top panel 104b, FIG. 5B is a perspective view of a SIM adapter 101b, FIG. 5C is a perspective view of a memory card 103, FIG. 5D is a cross-sectional view in a cutting surface taken along line a-a' in a state before the memory card 103 is inserted, and 5E is a cross-sectional view in the cutting surface taken along line a-a' in a state after the memory card 103 is inserted.

In the SIM adapter 101b according to the third embodiment, a spring 501 is provided on both ends (insertion-guiding portion) of the top panel 104b.

The spring 501 is a plate-like spring which is bent upward higher than the insertion-guiding portion in the drawing. By the spring 501, the top panel 104b is lowered when the memory card 103 is not inserted. The spring 501 provided on the top panel 104b holds to lower the top panel 104b when the memory card 103 is not inside. When the memory card 103 is inserted, the top panel 104b is pushed up by the memory card 103, and the spring 501 is pressed.

Although the one spring is exemplified here, a plurality of springs may be provided. Also, although the plate-like spring is exemplified, an elastic body such as a spiral-like spring may be attached on the both ends (insertion-guiding portion) of the top panel 104b.

Further, the top panel 104b may be formed of a metal plate, and a top-panel-holding portion 503 on the SIM adapter 101b may be similarly made of a metal. Still further, the top-panel-holding portion 503 may be connected with a GND terminal (not illustrated) on a circuit board of the SIM adapter 101b by soldering and be touched by the spring 501 on the top panel 104b, so that the top panel 104b has a GND potential, which results in suppressing noises and unnecessary radiation of electromagnetic waves for EMI reduction.

Still further, the SIM adapter 101b has a protrusion 502 in the card slot 102 on a side from which the memory card 103 is inserted. As a width of the card slot 102, a vicinity of a card-insertion opening is narrower than a portion where the top panel 104b is fitted, so that the protrusion 502 is formed. By the protrusion 502, it is prevent that the top panel 104b comes off from the insertion opening in the card slot 102. In spite of the fact that the top panel 104b is movable up and down, the top panel 104b does not come off because of having a structure that the protrusion of the top-panel-holding portion 503 contacts with a flange of the top panel, and in addition, does not drop because of having the structure of the protrusion 502. As described above, in the present embodiment, in spite of the up-and-down movable top panel, the top panel can be stably fitted in the SIM adapter.

### (Fourth Embodiment)

In a SIM adapter according to a fourth embodiment, when a memory card is not inserted, a top panel is pushed down to a thickness of the SIM adapter.

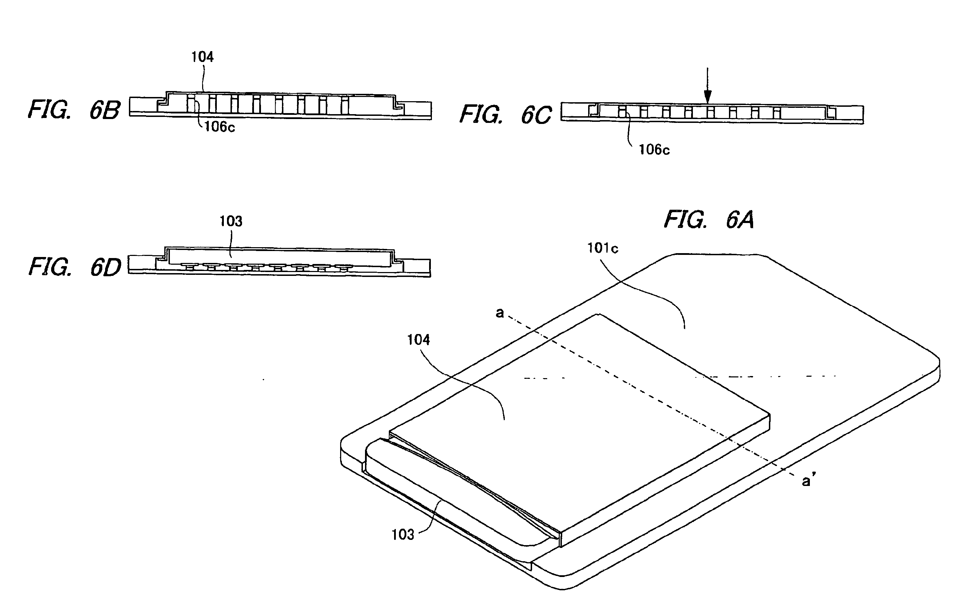

FIGs. 6A to 6D are views illustrating outlines of the SIM adapter according to the fourth embodiment of the present invention, FIG. 6A is a perspective view of a SIM adapter 101c, FIGs. 6B and 6C are cross-sectional views in a cutting surface taken along line a-a' in a state before a memory card 103 is inserted, and 6D is a cross-sectional view in the cutting surface taken along line a-a' in a state after the memory card 103 is inserted. FIG. 6B illustrates a state that a top panel 104 is not stressed, and FIG. 6C illustrates a state that the top panel 104 is stressed from above.

As illustrated in FIG. 6B, in the SIM adapter 101c according to the fourth embodiment, the top panel 104 is pushed up by urging force of a spring of a terminal strip 106c on the SIM adapter 101c when the memory card 103 is not inserted.

Also, as illustrated in FIG. 6C, although the memory card 103 is not inserted, when the SIM adapter 101c is inserted into a SIM socket or others and is pressed to have an original SIM thickness, the terminal strip 106c is pushed down by the top panel 104, so that the SIM adapter 101c has the original thickness. Therefore, the SIM adapter 101c is attachable in the SIM socket. And, when the SIM adapter 101c is inserted into the SIM socket, a force of pushing the top panel 104 outside is caused by restoring force of a spring on the terminal strip 106c, and therefore, the SIM adapter 101c is stably attached in the SIM socket, which results in preventing coming off of the SIM adapter.

Note that, while the spring 501 described in the fourth embodiment is the upward plate-like spring in the drawing, the spring can be formed downward to push the top panel 104 up.

Also, the spring 501 can be combined with the terminal strip 106c.

### (Fifth Embodiment)

In a SIM adapter according to a fifth embodiment of the present invention, there are prepared two types of a high removable top panel and a low removable top panel. The high top panel is used when a memory card is inserted, and the low top panel is used when the memory card is not inserted.

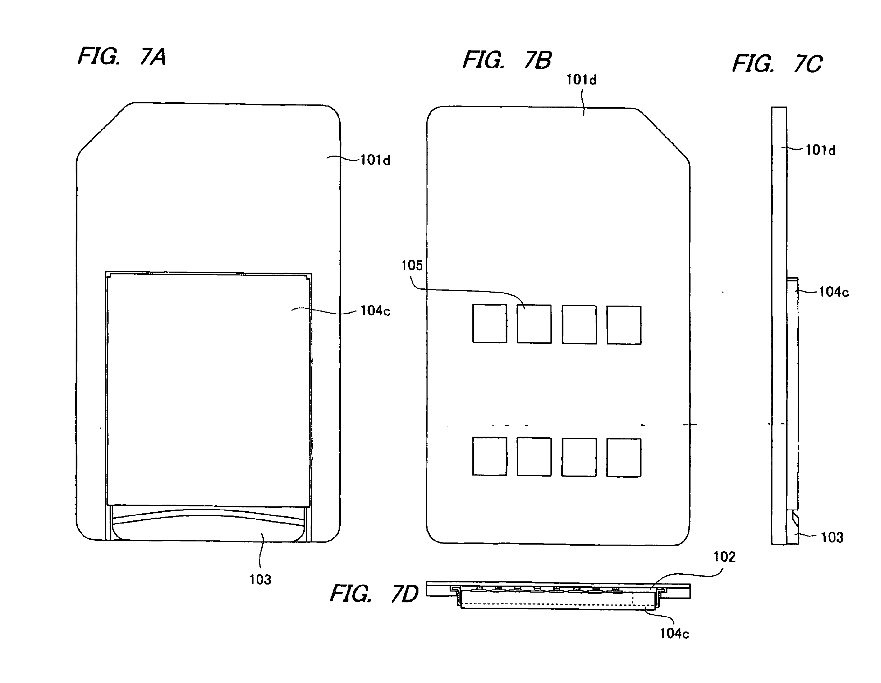

FIGs. 7A to 7D are views illustrating outlines of the SIM adapter according to the fifth embodiment of the present invention, FIG. 7A is a bottom view, FIG. 7B is a plan view, FIG. 7C is a right side view, and FIG. 7D is a front view. FIGs. 7A to 7D illustrate views in a state that a memory card 103 such as a microSD (trademark) is inserted into a card slot (recess portion) 102 in a SIM adapter 101d.

As illustrated in FIG. 7A, a removable top panel 104c covering the card slot 102 is inserted together with the memory card 103 into one surface of the SIM adapter according to the fifth embodiment. The top panel 104c has a convex shape and a height for storing the memory card 103. The top panel 104c has a thickness of, for example, about 0.1 µm, and is preferably made of a metal in consideration of its thinness and strength. However, the top panel 104c may be made of other material such as a resin. Also, as illustrated in FIG. 7B, on the other surface of the SIM adapter 101d, an ISO7816 electrode 105 is arranged. Further, one of four corners of the SIM adapter is chamfered.

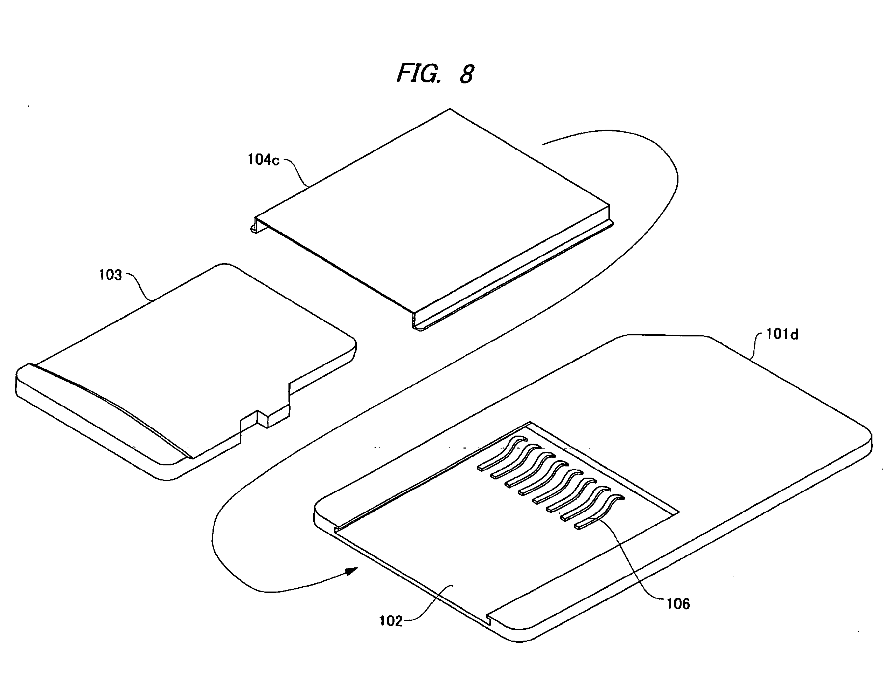

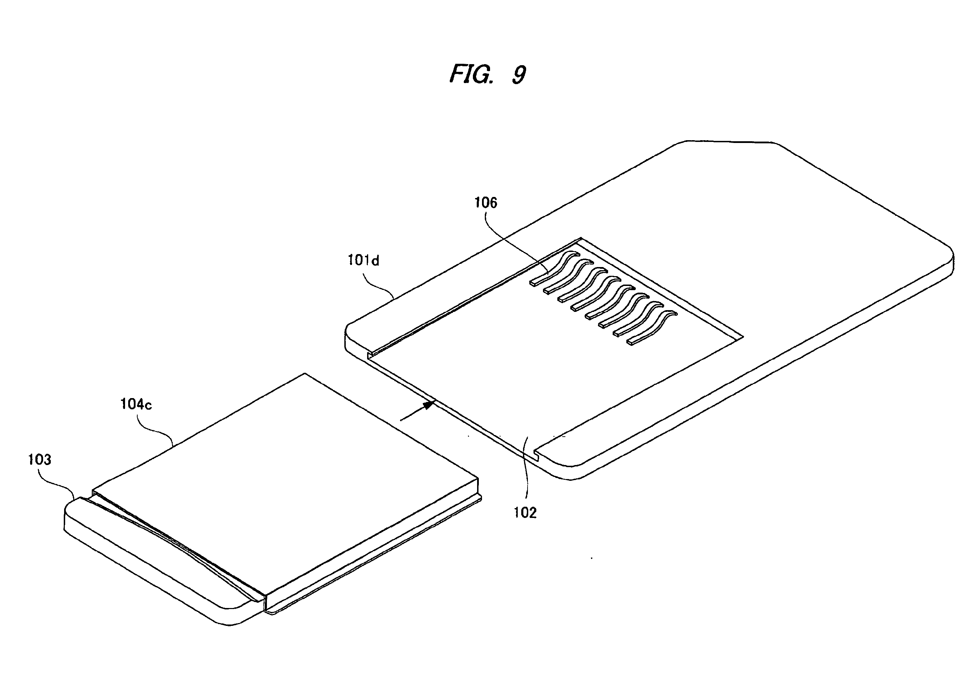

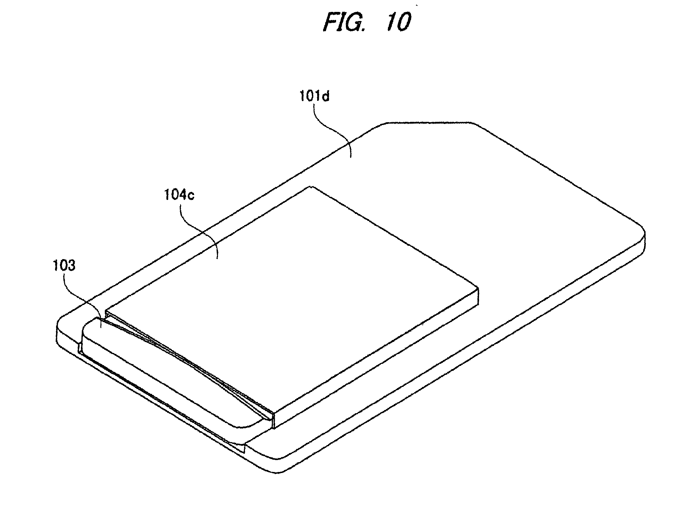

FIGs. 8 and 9 are views illustrating the memory card 103 and the top panel 104c in a state before they are inserted into the SIM adapter 101d. FIG. 10 is a view illustrating a state after the memory card 103 and the top panel 104c are inserted into the SIM adapter 101d. As illustrated in FIG. 9, the memory card 103 is attached in the high top panel 104c, and then, they are inserted into the SIM adapter 101d. On the card slot 102 in the SIM adapter 101d, a terminal strip 106 for electrically connecting between the SIM adapter and the memory card 103 is arranged. The terminal strip 106 on an insertion-opening side is soldered or adhered on the SIM adapter 101d, and the opposite side is opened. By adhering to lower the insertion-opening side, the memory card is not stuck with the terminal strip 106 when the memory card is inserted, so that damages of the terminal strip 106 are avoided.

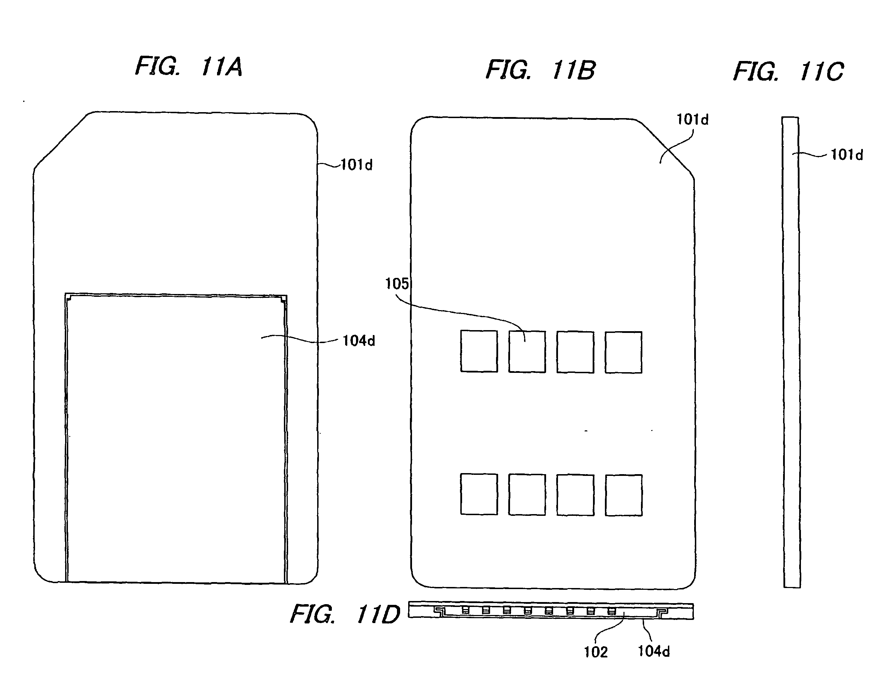

FIGs. 11A to 11D are views illustrating outlines of the SIM adapter according to the fifth embodiment of the present invention, FIG. 11A is a bottom view, FIG. 11B is a plan view, FIG. 11C is a right side view, and FIG. 11D is a front view. FIGs. 11A to 11D illustrate views in a state that the memory card 103 is not inserted into the card slot (recess portion) 102 in the SIM adapter 101d.

As illustrated in FIG. 11A, a removable top panel 104d for covering the card slot 102 is inserted into one surface of the SIM adapter according to the fifth embodiment. The top panel 104d has a convex shape, and is lower than the top panel 104c. By inserting the top panel 104d, a planar surface illustrated in FIG. 11A is flattened. The top panel 104d has a thickness of, for example, about 0.1 µm, and is preferably made of a metal in consideration of its thinness and strength. However, the top panel 104d may be made of other material such as a resin.

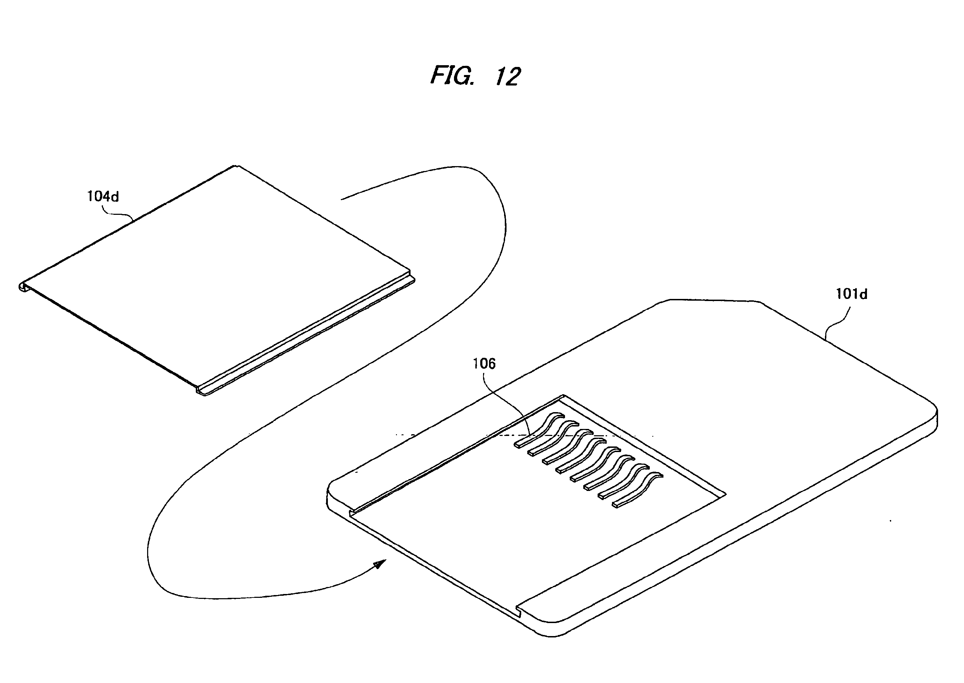

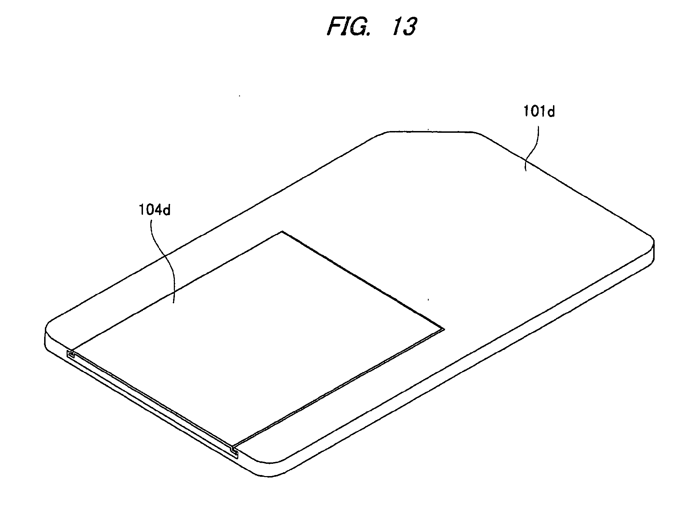

FIG. 12 is a view illustrating a state before the top panel 104d is inserted into the SIM adapter 101d. FIG. 13 is a view illustrating a state after the top panel 104d is inserted into the SIM adapter 101d.

When the memory card 103 is not attached in the SIM adapter 101d, the card slot 102 is covered by the low top panel 104d whose height is the same as the thickness of the SIM adapter 101d. And, the terminal strip 106 is protected by the top panel 104d.

### (Sixth Embodiment)

In a sixth embodiment, an insulating sheet for preventing short circuit is adhered on the low top panel described in the fifth embodiment in the state when the memory card is not inserted.

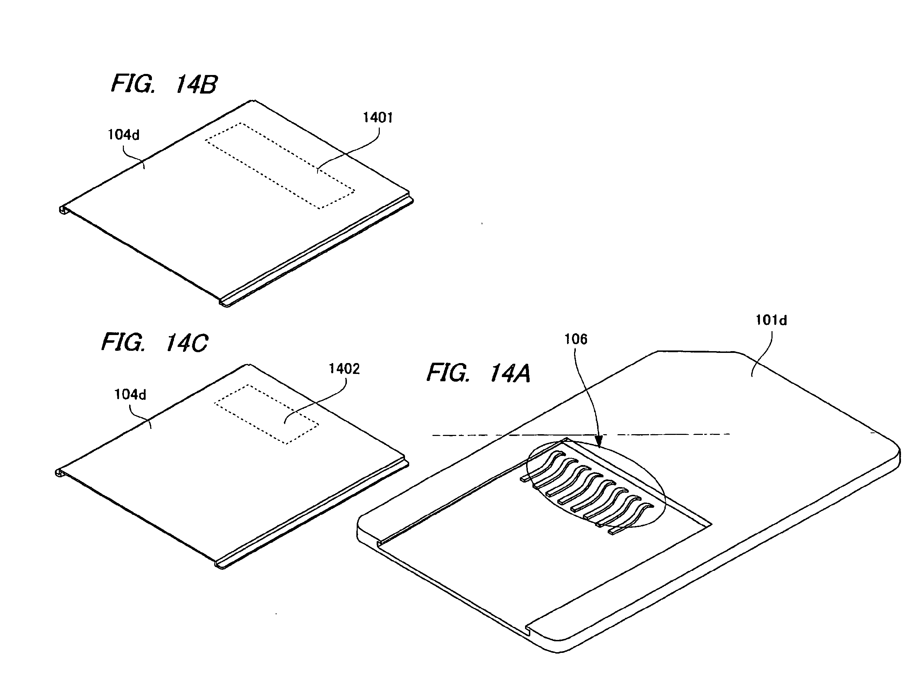

FIGs. 14A to 14C are perspective views illustrating outlines of a SIM adapter and top panels according to the sixth embodiment of the present invention, FIG. 14A illustrates the SIM adapter, and FIGs. 14B and 14C illustrate the top panels on which the insulating sheet for preventing short circuit is adhered.

As illustrated in FIG. 14B, by adhering an insulating sheet 1401 on a rear surface of a top panel 104d made of a metal, when the top panel 104d is inserted into a SIM adapter 101d, the insulating sheet prevents a contact of a terminal strip 106, and therefore, it is possible to prevent the short circuits among the terminal strips 106.

Also, as illustrated in FIG. 14C, by partially cutting out an insulating sheet 1402 for preventing the contact with the terminal strip 106, circuits are purposely shorted out among specific terminal strips. Depending on a type of the top panel in the state when the memory card is not inserted, a shape of the insulating sheet 1402 is changed. By electrically detecting the short circuits among the terminal strips on the SIM adapter 101d side, the type of the top panel can be detected. And, insertion/non-insertion of the memory card can be electrically detected.

Note that the invention is employed for the two types of the removable top panels according to the fifth embodiment in the sixth embodiment. However, the invention can be also employed for the movable top panel according to the first to fourth embodiments.

### (Seventh Embodiment)

In a seventh embodiment, a cutout for detecting a type of a top panel is provided in the two-type top panels described in the fifth embodiment.

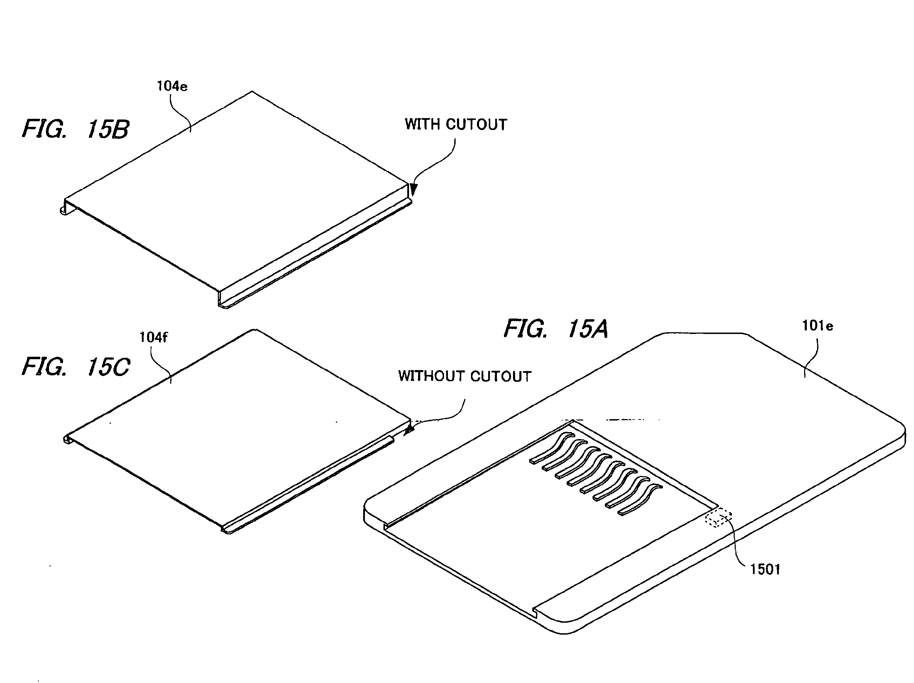

FIGs. 15A to 15C are perspective views illustrating outlines of a SIM adapter and top panels according to the seventh embodiment of the present invention, FIG. 15A illustrates the SIM adapter, FIG. 15B illustrates a high top panel for inserting a memory card, and 15C illustrates a low top panel.

For example, as illustrated in FIG. 15B, the cutout is not provided in a top panel 104e in which the memory card is attached. As illustrated in FIG. 15C, the cutout is provided in a top panel 104f in which the memory card is not attached. A detecting switch 1501 is provided at a portion where the cutout is positioned when the top panel is inserted into the SIM adapter 101e. And, existence or nonexistence of the cutout is detected by the detecting switch 1501, so that the type of the top panel is identified. Therefore, the operation for detecting existence or nonexistence of the memory card or others can be performed by the identification of the top panel.

### (Eighth Embodiment)

In an eighth embodiment, on the two-type top panels described in the fifth embodiment, a latch for preventing coming off of each top panel is provided.

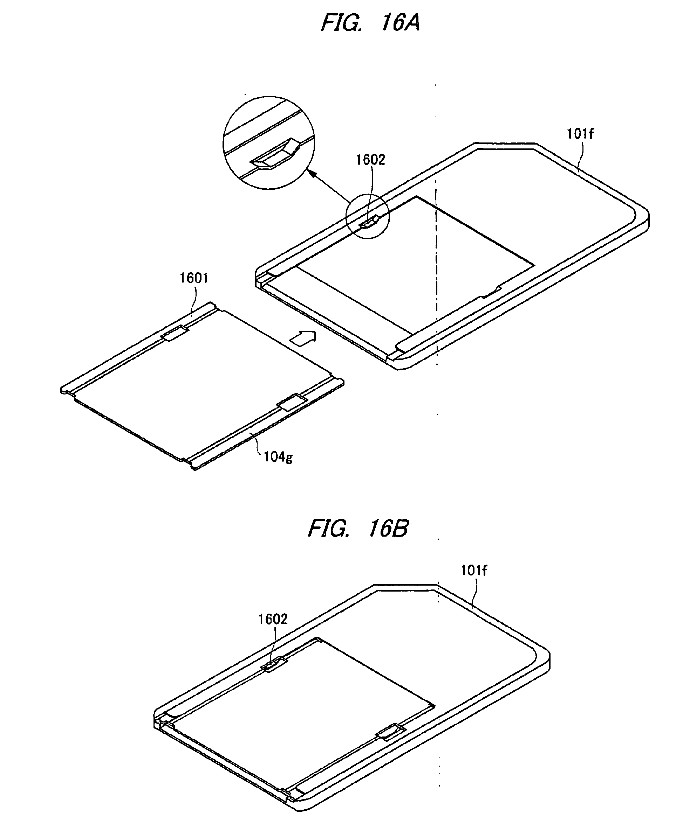

FIGs. 16A and 16B are perspective views illustrating outlines of a SIM adapter and a top panel according to the eighth embodiment of the present invention, FIG. 16A illustrates a state before the top panel is inserted into the SIM adapter, and FIG. 16B illustrates a state after the top panel is inserted into the SIM adapter.

As illustrated in FIG. 16A and 16B, a cutout 1601 is provided in an insertion-guiding portion of a top panel 104g so as to engage with a latch 1602 having a spring structure provided on a SIM adapter 101f side, so that a mechanism of preventing the coming off is provided. The latch has a function that a part of a metal plate pushed by the top panel 104g is formed in a convex shape for the top panel 104g. By adjusting a dimension of the convex shape of the latch 1602 and an angle of the same, a holding force of the top panel 104g can be adjusted. Therefore, the cutout (hole) 1601 in the top panel 104g and the latch (protrusion) 1602 in the SIM adapter 101f are fitted with each other, so that the top panel 104g is latched for preventing the coming off. Note that the top panel 104g can be pulled out from the SIM adapter 101f by applying a certain force or stronger.

### (Ninth Embodiment)

In a ninth embodiment, a blank card without a memory functionality is inserted in stead of the low top panel used when the memory card is not inserted which is described in the fifth embodiment.

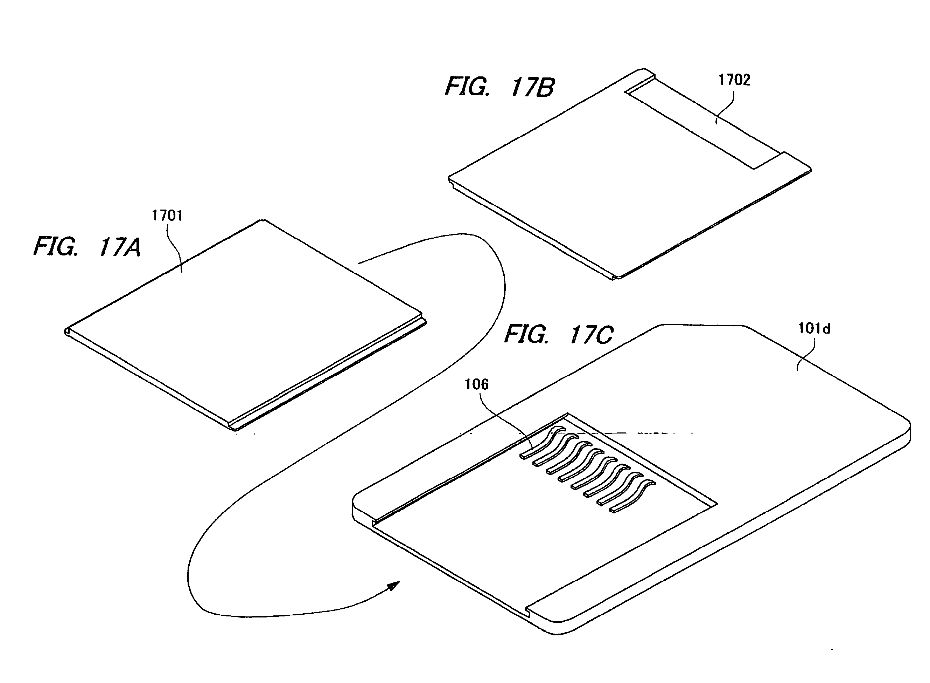

FIGs. 17A to 17C are perspective views illustrating outlines of a SIM adapter and the blank card according to the ninth embodiment of the present invention, FIG. 17A illustrates a view from a front side of the blank card, FIG. 17B illustrates a view from a rear side of the same, and FIG. 17C illustrates the SIM adapter.

As illustrated in FIGs. 17A to 17C, when the memory card is not inserted into the SIM adapter 101d, a blank card 1701 without a memory functionality whose thickness is the same as that of the SIM adapter is inserted. As illustrated in FIG. 17A, a shape of the blank card 1701 is convex, and a resin or others is used as its material. The blank card 1701 has a thickness not forming a convex portion on a surface of the SIM adapter 101d when the blank card is not inserted. By using a thick and hard member for the blank card 1701, strength of the card against an external force such a stress is increased, so that breakage of the same is prevented. That is, by inserting the blank card 1701 in stead of the top panel, surface convexity is decreased compared with inserting the memory card, and therefore, a stable shape of the SIM adapter is maintained even in not inserting the memory card.

Also, the SIM adapter 101d has a terminal strip 106 contacting with the memory card for electrically connecting between the SIM adapter and the memory card. As illustrated in FIG. 17b, a concave terminal-strip relief portion 1702 is provided on a portion on a rear side of the blank card 1701 facing the terminal strip 106. By the terminal-strip relief portion, damages of the terminal strip 106 can be prevented.

### (Tenth Embodiment)

In a tenth embodiment, a terminal-strip guiding trench is provided on a terminal-strip portion in a SIM adapter, and the terminal strip is embedded inside the terminal-strip guiding trench, so that the terminal strip is protected.

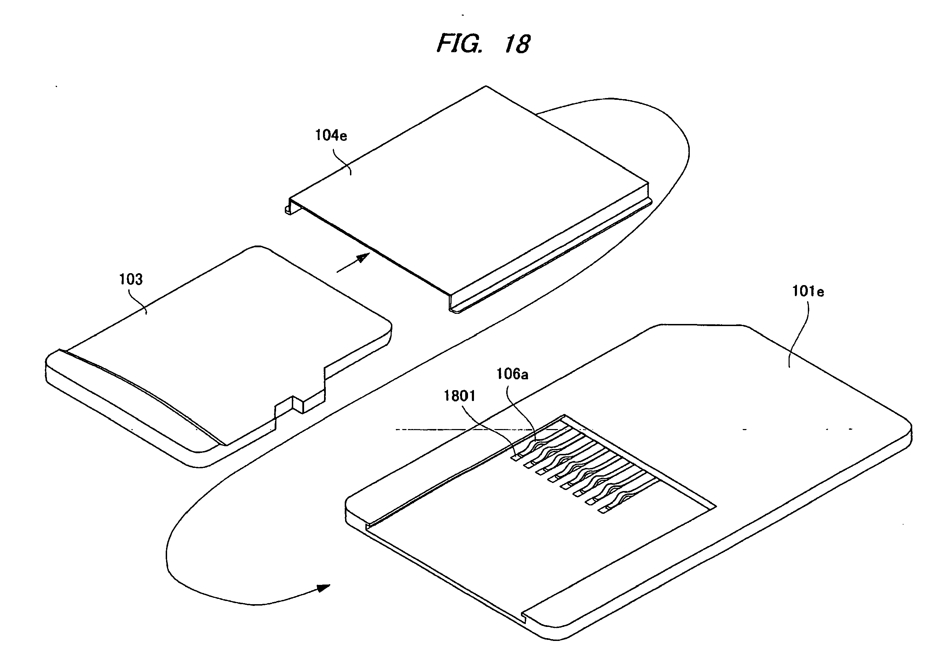

FIG. 18 is a view illustrating outlines of a memory card 103 and a top panel 104e in a state before they are inserted into a SIM adapter 101e.

As illustrated in FIG. 18, a terminal-strip guiding trench 1801 is provided on a portion of a terminal strip 106a in a SIM adapter 101e.

One end of the terminal strip 106a provided in the SIM adapter 101e is fixed on the SIM adapter 101e and is connected with a circuit of the SIM adapter 101e, and the other end of the same moves as deforming when the other end is pushed by the memory card 103 and is contacted with a terminal of the memory card 103. At this time, the terminal-strip guiding trench 1801 guides the movement of the terminal strip 106a so that a tip of the terminal strip 106a is embedded inside the terminal-strip guiding trench 1801 so as not to hit the memory card 103. In this manner, damages of the terminal strip can be prevented.

### (Eleventh Embodiment)

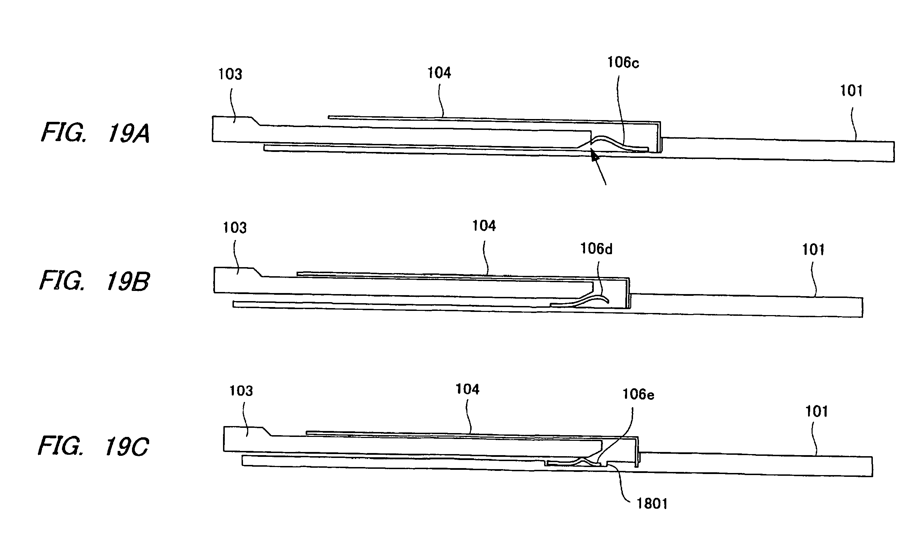

FIGs. 19A to 19C are views illustrating a structure of a terminal strip in a SIM adapter according to an eleventh embodiment of the present invention. FIGs. 19A to 19C illustrate a shape comparison among each terminal strip in the SIM adapter.

When the memory card is inserted into a card slot of the SIM adapter, it is concerned that the memory card is stuck with the terminal strip, which results in breaking the memory card or the terminal strip. Accordingly, shapes for preventing the damage of the terminal strip have been considered.

In the terminal strip 106c illustrated in FIG. 19A, its one end on the side from which the memory card 103 is inserted is opened, and the other end on the opposite side is adhered on the SIM adapter 101. In this shape, it is concerned that the memory card 103 hits the terminal strip 106c, which results in deforming or breaking the terminal strip 106c.

In the terminal strip 106d illustrated in FIG. 19B, its one end on the side from which the memory card 103 is inserted is adhered on the SIM adapter 101, and the other end on the opposite side is opened. In this shape, when the memory card 103 is inserted, the memory card 103 naturally moves onto a slope surface of the terminal strip 106d because of the shape of the terminal strip 106d. The memory card 103 is inserted as pushing down the terminal strip 106d having springiness, so that the contact with a terminal of the memory card 103 is obtained.

The terminal strip 106e illustrated in FIG. 19C has the structure of embedding the terminal strip itself inside the guiding trench 1801. In this shape, the memory card 103 can be inserted without hitting the terminal strip 106e. The guiding trench 1801 guides the movement of the tip of the terminal strip 106e, so that the function of maintaining the contact position of the terminal of the memory card 103 can be also obtained.

### (Twelfth Embodiment)

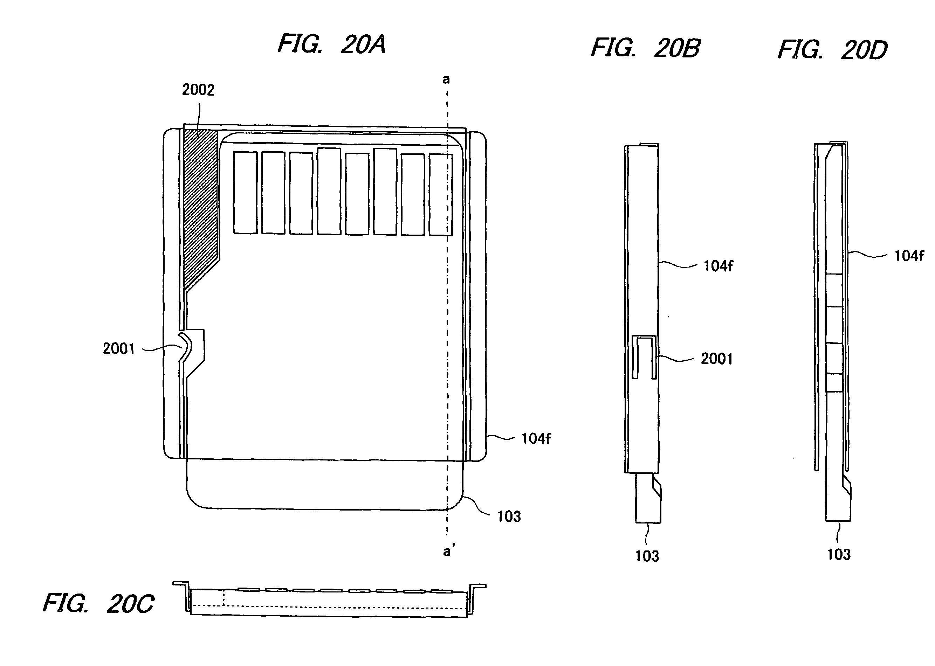

FIGs. 20A to 20D are views illustrating a structure of a top panel according to a twelfth embodiment of the present invention, FIG. 20A is a plan view, FIG. 20B is a side view, FIG. 20C is a front view, and FIG. 20D is a cross-sectional view in a cutting surface taken along line a-a'. FIGs. 20A to 20D illustrate views in a state that a memory card is attached in the top panel.

As illustrated in FIGs. 20A to 20D, a coming-off preventing spring 2001 is provided on a side surface of a top panel 104f. Also, a reverse-insertion preventing portion 2002 matched with a shape of a memory card 103 is provided. By the coming-off preventing spring 2001, it is possible to prevent the coming off of the memory card 103 from the top panel 104f. Further, by the reverse-insertion preventing portion 2002, it is possible to prevent the reverse-insertion of the memory card 103.

Note that only either the coming-off preventing spring or the reverse-insertion preventing portion may be provided depending on an adapter.

### (Thirteenth Embodiment)

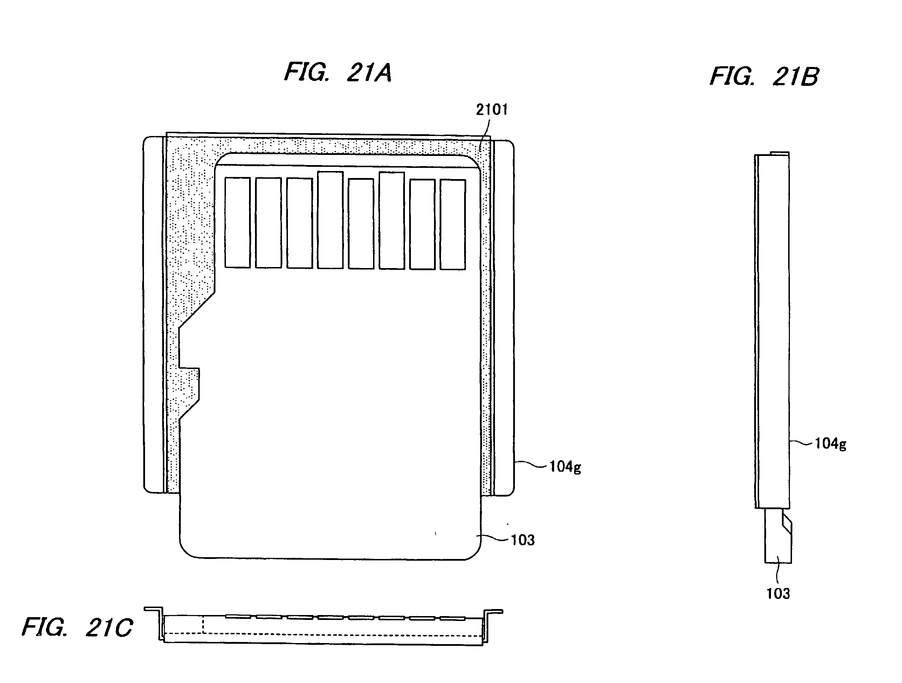

FIGs. 21A to 21C are views illustrating a structure of a top panel according to a thirteenth embodiment of the present invention, FIG. 21A is a plan view, FIG. 21B is a side view, and FIG. 21C is a front view. FIGs. 21A to 21C illustrate views in a state that a memory card is attached in the top panel.

As illustrated in FIGs. 21A to 21C, an interior member 2101 matched with a shape of the memory card is provided inside a top panel 104g by filling resin or others.

The interior member 2101 becomes a female mold for the shape of the memory card 103, and the memory card 103 is tightly stored in the top panel 104g, and therefore, a position of the memory card 103 is easily determined, so that a reverse-insertion of the memory card 103 is prevented.

### (Fourteenth Embodiment)

In a top panel according to a fourteenth embodiment, a flange (insertion guiding portion) of the top panel according to the twelfth embodiment is partially bent to provide an attachment for preventing to drop the memory card.

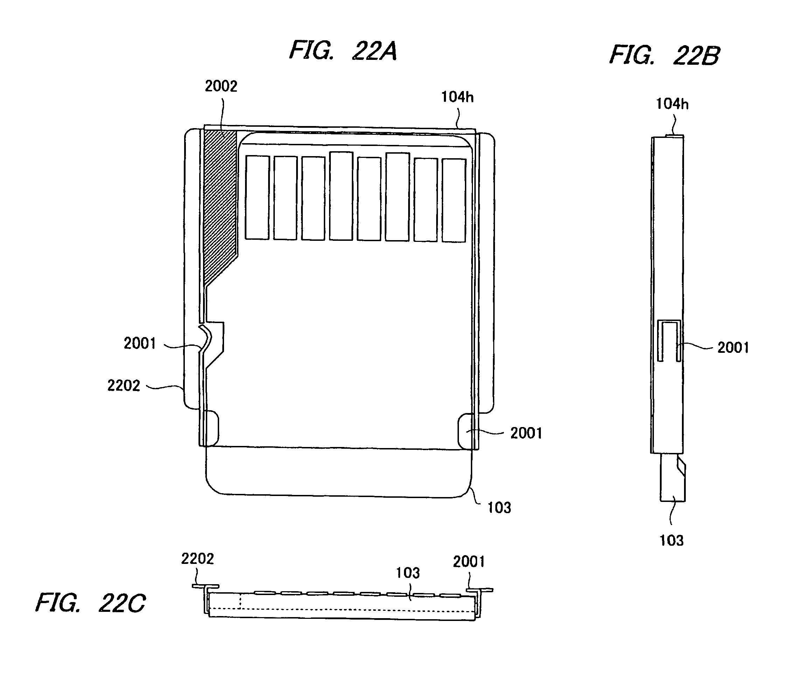

FIGs. 22A to 22C are views illustrating a structure of a top panel according to the fourteenth embodiment of the present invention, FIG. 22A is a plan view, FIG. 22B is a side view, and FIG. 22C is a front view. FIGs. 22A to 22C illustrate views in a state that a memory card is attached in the top panel.

As illustrated in FIGs. 22A to 22C, each flange (insertion guiding portion) on both ends of a top panel 104h is partially bent inward (memory-card side) by an angle of 180 degrees, so that a top-panel attachment 2202 is provided.

By the top-panel attachment 2202, the coming-off of the memory card 103 can be prevented with inserting the memory card 103 into the top panel 104h.

### (Fifteenth Embodiment)

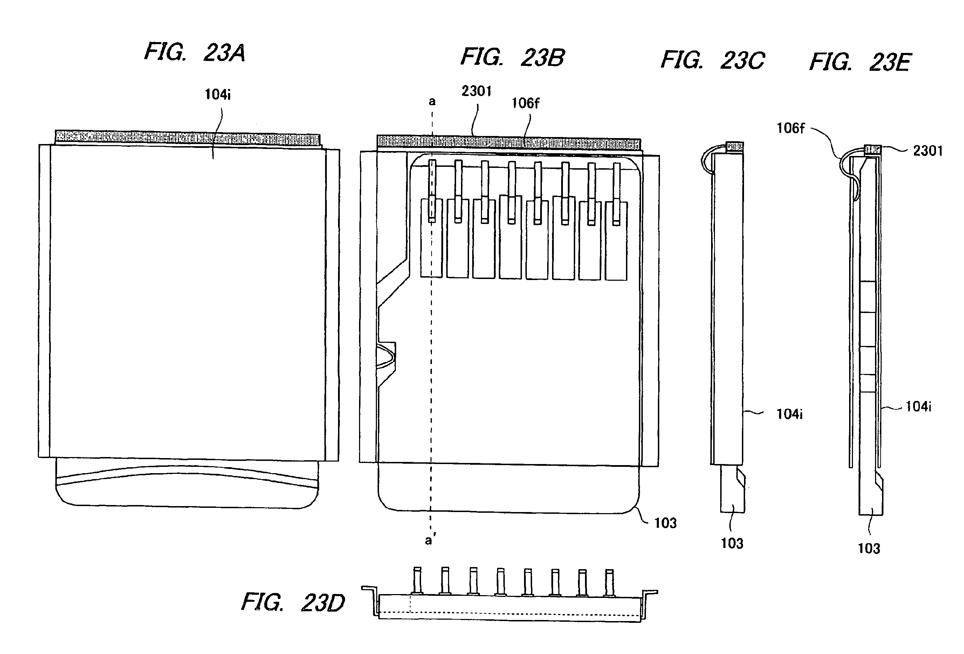

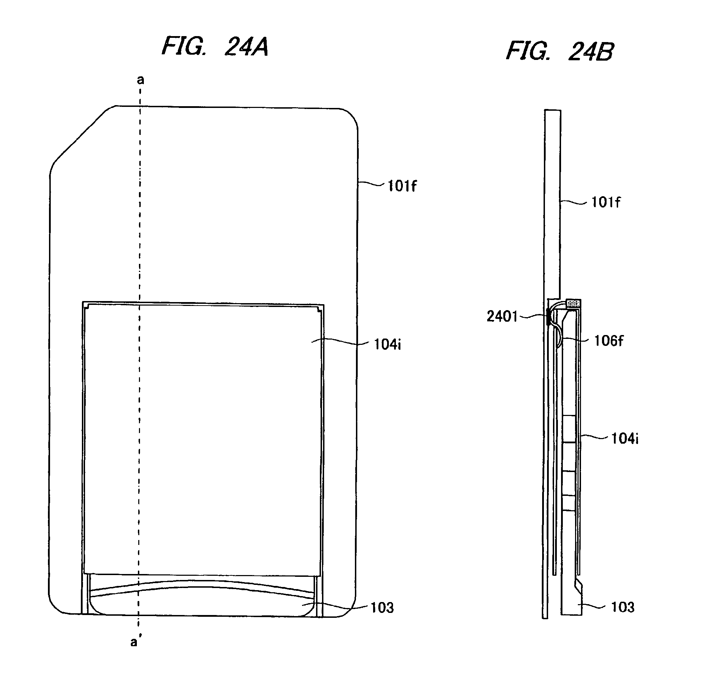

FIGs. 23A to 23E are views illustrating a structure of a top panel according to a fifteenth embodiment of the present invention, FIG. 23A is a bottom view, FIG. 23B is a plan view, FIG. 23C is a side view, FIG. 23D is a front view, and FIG. 23E is a cross-sectional view in a cutting surface taken along line a-a'. FIGs. 23A to 23E illustrate views in a state that a memory card is attached in the top panel. FIGs. 24A and 24B are views illustrating structures of the top panel and a SIM adapter according to the fifteenth embodiment of the present invention, FIG. 24A is a plan view, and FIG. 24B is a cross-sectional view in a cutting surface taken along line a-a'.
FIGs. 24A and 24B illustrate views in a state that a top panel 104i is inserted into a SIM adapter 101f.

As illustrated in FIGs. 23A to 23E, a terminal-strip holding member 2301 is adhered in the top panel 104i on an opposite side to the insertion-opening side from which the memory card is inserted, and an S-shaped-spring terminal strip 106f is provided from the terminal-strip holding member 2301 toward a terminal side. An insulating material such as a resin is used for the terminal-strip holding member 2301.

As illustrated in FIGs. 24A and 24B, a terminal 2401 on the SIM adapter 101f and the terminal 106f on the top panel 104i are contacted with each other, so that electrical connection with the memory card 103 is achieved. Only a planar-shaped electrode terminal is attached on a board of the SIM adapter 101f, and the terminal-strip unit 106 illustrated in FIG. 5 is not necessarily attached thereon.

That is, the terminal strip 106f is provided on the top panel 104i, and only the electrode terminal is provided on the SIM adapter. The terminal strip 106f provided on the top panel 104i contacts with the terminal of the memory card 103, and also contacts with a terminal 2401 of the SIM adapter. By providing, on the top panel 104i, the terminal strip 106f for electrically connecting between the terminal of the memory card 103 and the terminal of the SIM adapter, the terminal strip is unnecessary on the SIM adapter side, so that cost reduction of the SIM adapter is achieved.

### (Sixteenth Embodiment)

A sixteenth embodiment is a modified example of the fifteenth embodiment.

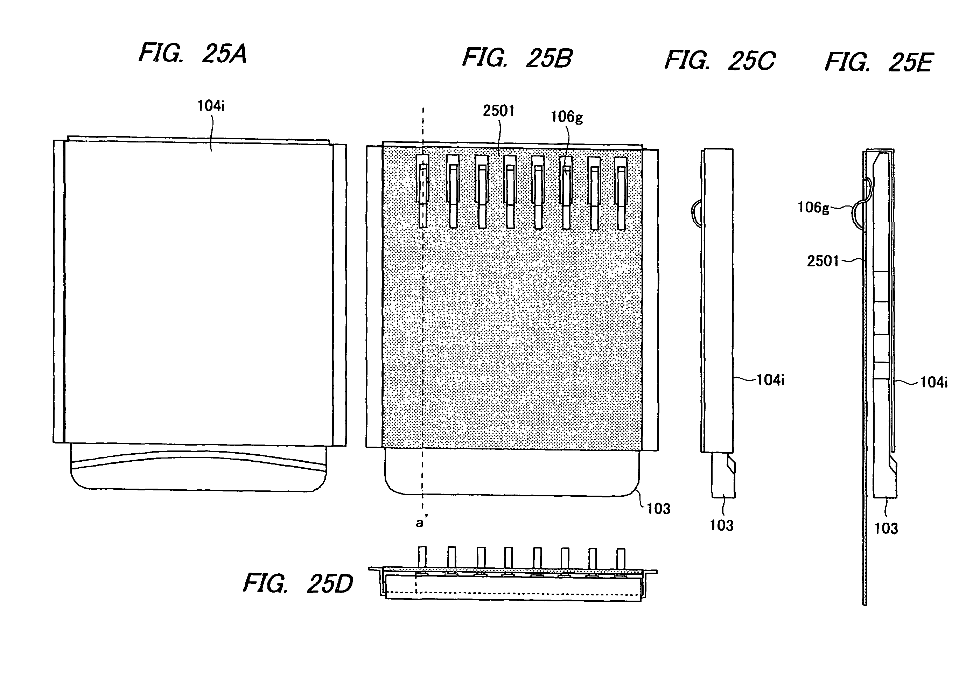

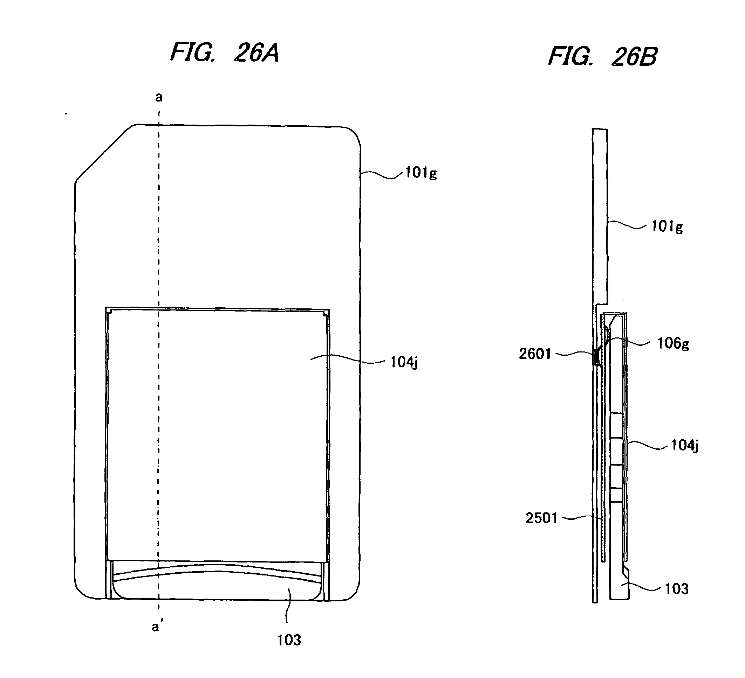

FIGs. 25A to 25E are views illustrating a structure of a top panel according to the sixteenth embodiment of the present invention, FIG. 25A is a bottom view, FIG. 25B is a plan view, FIG. 25C is a side view, FIG. 25D is a front view, and FIG. 25E is a cross-sectional view in a cutting surface taken along line a-a'. FIGs. 25A to 25E illustrate views in a state that a memory card is attached in the top panel. FIGs. 26A and 26B are views illustrating structures of the top panel and a SIM adapter according to the sixteenth embodiment of the present invention, FIG. 26A is a plan view, and FIG. 26B is a cross-sectional view in a cutting surface taken along line a-a'. FIGs. 26A and 26B illustrate views in a state that a top panel 104j is inserted into a SIM adapter 101g.

As illustrated in FIGs. 25A to 25E, a terminal-strip holding plate 2501 is provided on a rear side of the top panel 104j, and an S-shaped-spring terminal strip 106g is arranged on the terminal-strip holding plate 2501. An insulating material such as a resin is used for the terminal-strip holding plate 2501.

As illustrated in FIGs. 26A and 26B, a planar-shaped electrode terminal 2601 on the SIM adapter 101g and the terminal strip 106g on the top panel 104j are contacted with each other, so that electrical connection with a memory card 103 is achieved. Only the electrode terminal is attached on a board of the SIM adapter 101g, and the terminal-strip unit is not necessarily attached thereon.

That is, the terminal strip 106g is arranged on the terminal-strip holding plate 2501 provided on the rear side of the top panel 104j, and only the electrode terminal is provided on the SIM adapter. The terminal strip 106g provided on the terminal-strip holding plate 2501 contacts with the terminal of the memory card 103, and also contacts with the terminal of the SIM adapter. By providing, on the top panel 104j, the terminal strip 106g for electrically connecting between the terminal of the memory card 103 and the terminal of the SIM adapter, the terminal strip is unnecessary on the SIM adapter side, so that cost reduction of the SIM adapter is achieved.

### (Seventeenth Embodiment)

A seventeenth embodiment is a modified example of the sixteenth embodiment.

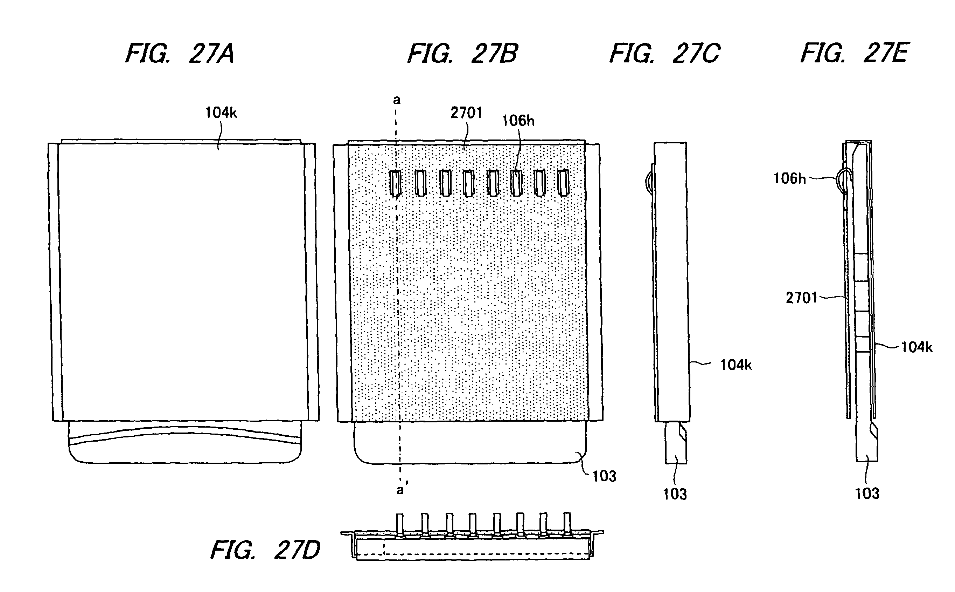

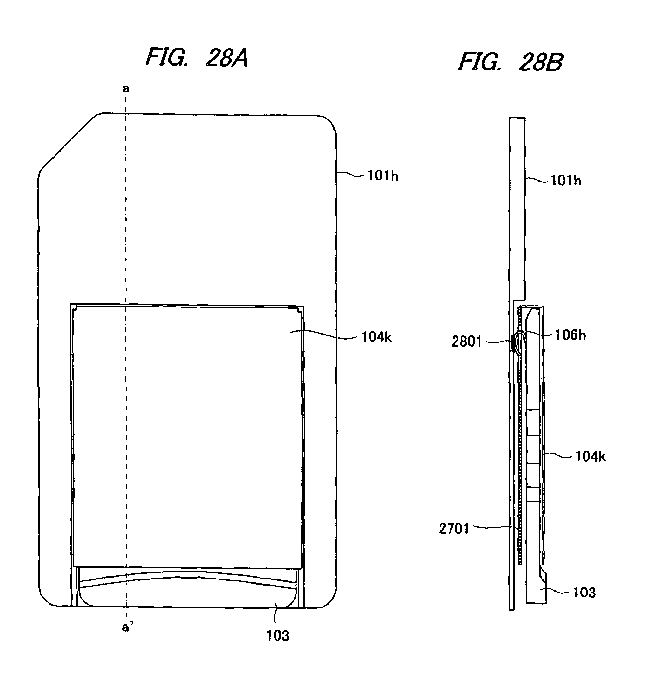

FIGs. 27A to 27E are views illustrating a structure of a top panel according to the seventeenth embodiment of the present invention, FIG. 27A is a bottom view, FIG. 27B is a plan view, FIG. 27C is a side view, FIG. 27D is a front view, and FIG. 27E is a cross-sectional view in a cutting surface taken along line a-a'. FIGs. 27A to 27E illustrate views in a state that a memory card is attached in the top panel. FIGs. 28A and 28B are views illustrating structures of the top panel and a SIM adapter according to the seventeenth embodiment of the present invention, FIG. 28A is a plan view, and FIG. 28B is a cross-sectional view in a cutting surface taken along line a-a'. FIGs. 28A and 28B illustrate views in a state that a top panel 104k is inserted into a SIM adapter 101h.

As illustrated in FIGs. 27A to 27E, a terminal-strip holding plate 2701 is provided on a rear side of the top panel 104k, and a U-shaped-spring terminal strip 106h is arranged on the terminal-strip holding plate 2701. An insulating material such as a resin is used for the terminal-strip holding plate 2701.

As illustrated in FIGs. 28A and 28B, a planar-shaped electrode terminal 2801 on the SIM adapter 101h and the terminal strip 106h on the top panel 104k are contacted with each other, so that electrical connection with a memory card 103 is achieved. Only the electrode terminal is attached on a board of the SIM adapter 101h, and the terminal-strip unit is not necessarily attached thereon.

That is, the terminal strip 106h is arranged on the terminal-strip holding plate 2701 provided on the rear side of the top panel 104k, and only the electrode terminal is provided on the SIM adapter 101h. The terminal strip 106h provided on the terminal-strip holding plate 2701 contacts with the terminal of the memory card 103, and also contacts with the terminal of the SIM adapter 101h. By providing, on the top panel 104k, the terminal strip 106h for electrically connecting between the terminal of the memory card 103 and the terminal of the SIM adapter 101h, the terminal strip is unnecessary on the SIM adapter side, so that cost reduction of the SIM adapter is achieved.

### (Eighteenth Embodiment)

An eighteenth embodiment is a modified example of the sixteenth embodiment.

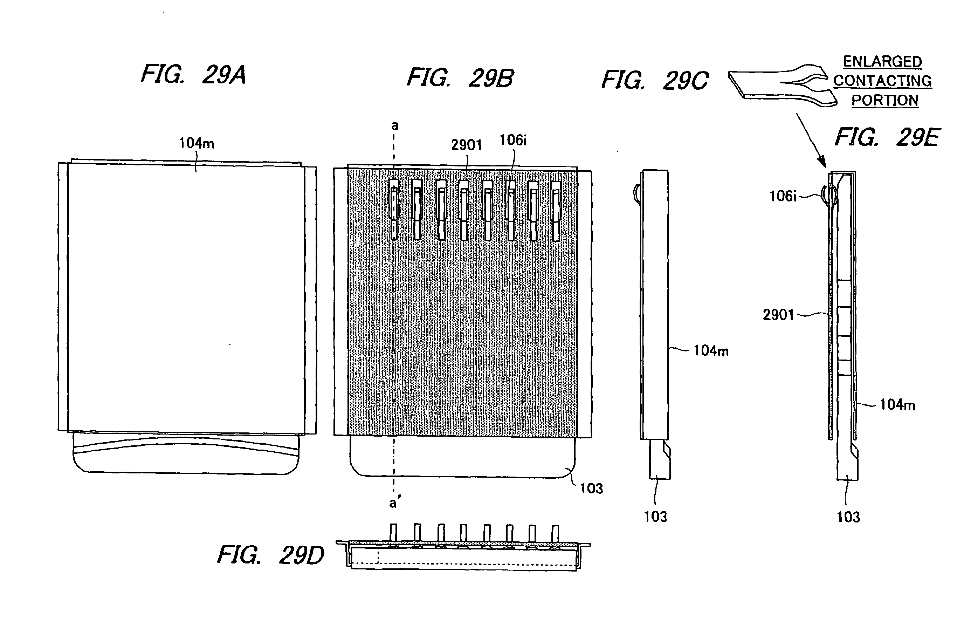

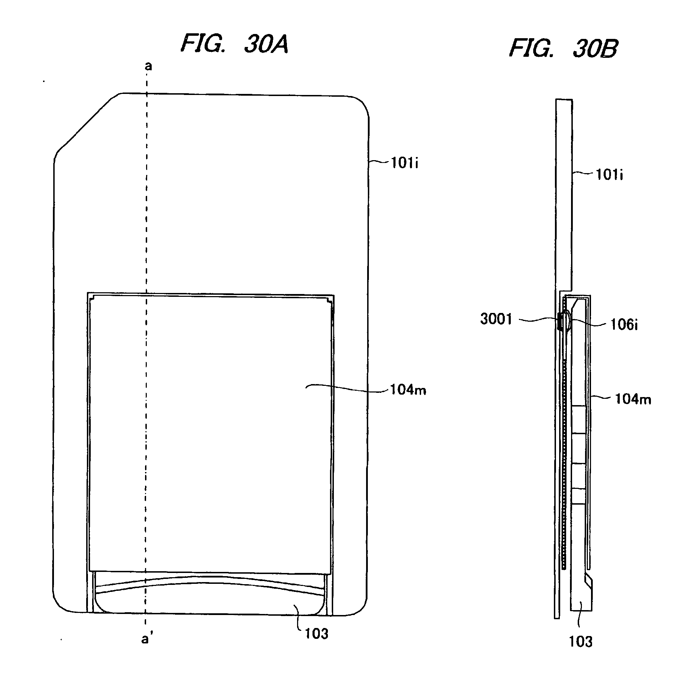

FIGs. 29A to 29E are views illustrating a structure of a top panel according to the eighteenth embodiment of the present invention, FIG. 29A is a bottom view, FIG. 29B is a plan view, FIG. 29C is a side view, FIG. 29D is a front view, and FIG. 29E is a cross-sectional view in a cutting surface taken along line a-a'. FIGs. 29A to 29E illustrate views in a state that a memory card is attached in the top panel. FIGs. 30A and 30B are views illustrating structures of the top panel and a SIM adapter according to the eighteenth embodiment of the present invention, FIG. 30A is a plan view, and FIG. 30B is a cross-sectional view in a cutting surface taken along line a-a'. FIGs. 30A and 30B illustrate views in a state that a top panel 104m is inserted into a SIM adapter 101i.

As illustrated in FIGs. 29A to 29E, a terminal-strip holding plate 2901 is provided on a rear side of the top panel 104m, and a V-shaped-spring terminal strip 106i is arranged on the terminal-strip holding plate 2901. An insulating material such as a resin is used for the terminal-strip holding plate 2901.

As illustrated in FIGs. 30A and 30B, a planar-shaped electrode terminal 3001 on the SIM adapter 101i and the terminal strip 106i on the top panel 104m are contacted with each other, so that electrical connection with a memory card 103 is achieved. Only the electrode terminal is attached on a board of the SIM adapter 101i, and the terminal-strip unit is not necessarily attached thereon.

That is, the terminal strip 106i is arranged on the terminal-strip holding plate 2901 provided on the rear side of the top panel, 104m, and only the electrode terminal is provided on the SIM adapter 101i. The terminal strip 106i provided on the terminal-strip holding plate 2901 contacts with the terminal of the memory card 103, and also contacts with the terminal of the SIM adapter 101i. By providing, on the top panel 104m, the terminal strip 106i for electrically connecting between the terminal of the memory card 103 and the terminal of the SIM adapter 101i, the terminal strip is unnecessary on the SIM adapter side, so that cost reduction of the SIM adapter is achieved.

### (Nineteenth Embodiment)

In a nineteenth embodiment, a card on which a microcomputer for processing a NFC (abbreviation of Near Field Communication: short-range wireless communication) is mounted is inserted into a SIM adapter to expand the NFC functionality.

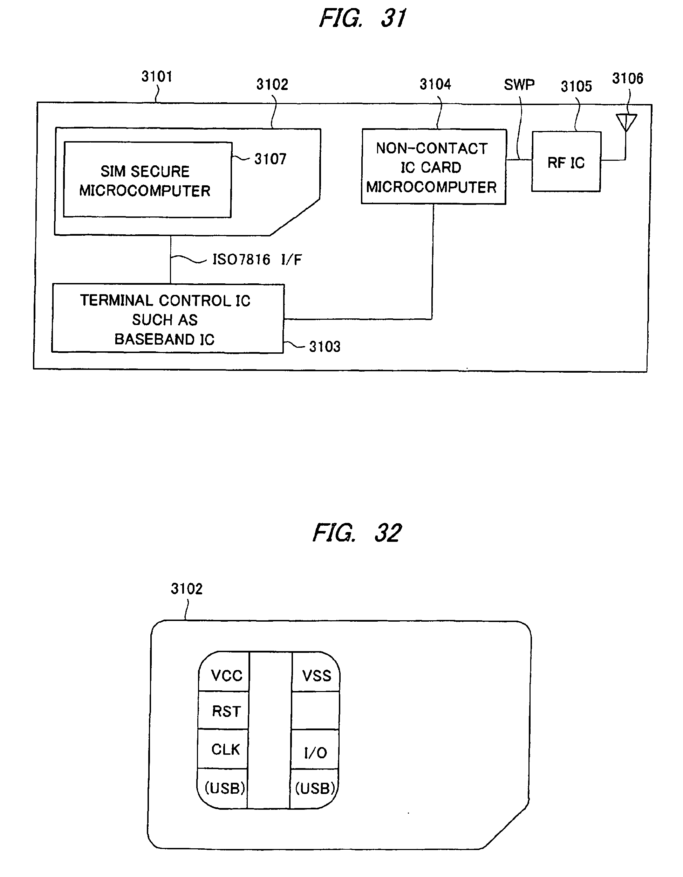

FIG. 31 is a block diagram illustrating a configuration of a mobile terminal studied as a precondition of the present invention. FIG. 32 is a diagram illustrating an example of a terminal arrangement (ISO7816 terminals) on a rear surface of a SIM card illustrated in FIG. 31.

A mobile terminal 3101 studied as a precondition of the present invention includes, for example: a SIM card 3102 on which a SIM secure microcomputer 3107 is mounted; a terminal control IC 3103 such as a baseband IC; a NFC non-contact IC card microcomputer 3104 for the NFC processing; a RFIC (Radio Frequency Integrated Circuit) 3105 having a functionality for processing high frequency (Radio Frequency) signals and others; an antenna 3106; and others. An ISO7816 I/F connects between the SIM card 3102 and the terminal control IC 3103 such as a baseband IC, and a standard-communication I/F for a non-contact card such as SWP (abbreviation of Single Wire Protocol) connects between the non-contact IC card microcomputer 3104 and the RFIC 3105.

In the configuration illustrated in FIG. 31, the NFC non-contact IC card microcomputer 3104, the RFIC 3105, the antenna 3106, and others are mounted on the mobile terminal 3101 as the NFC functionality, and therefore, the functionality cannot be expanded.

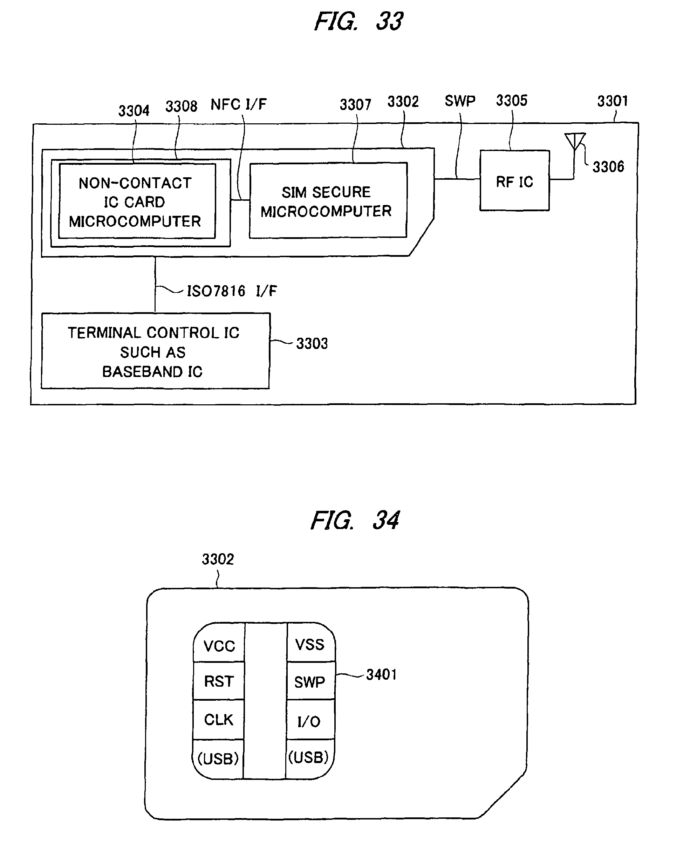

FIG. 33 is a block diagram illustrating a configuration of a mobile terminal according to the nineteenth embodiment of the present invention. FIG. 34 is a diagram illustrating an example of a terminal arrangement (ISO7816 terminals and SWP terminal) on a rear surface of the SIM adapter illustrated in FIG. 33.

A mobile terminal 3301 according to the nineteenth embodiment includes, for example: a SIM adapter 3302 on which a SIM secure microcomputer 3307 is mounted; a terminal control IC 3303 such as a baseband IC; a RFIC 3101; an antenna 3306; and others. An IS07816 I/F connects between the SIM adapter 3302 and the terminal control IC 3303 such as a baseband IC, and a standard-communication I/F for a non-contact card such as SWP contacts between the SIM adapter 3302 and the RFIC 3101. Into the SIM adapter 3302, a micro card 3308 having the NFC functionality on which a non-contact IC card microcomputer 3304 is mounted is inserted.

As illustrated in FIG. 33, an expansion card having the functionality of the NFC non-contact IC card microcomputer and the functionality of the Near Field Communication (NFC) used for a non-contact IC card or others is mounted on the SIM adapter, so that the functionality expansion is freely achieved without preparing a new expansion socket or others on the terminal side.

Compared with FIGs. 41 and 5, the memory card 103 is replaced with a micro card (card) 3308 having the NFC functionality.

Also, as illustrated in FIG. 34, in the terminal arrangement on the rear surface of the SIM adapter 3302, a SWP terminal 3401 is provided in an available terminal in the IS07816 as a functionality-expansion terminal for the RFIC I/F.

The micro card 3308 is inserted into the SIM adapter 3302, and the SIM adapter 3302 is connected with a mobile phone, so that the SWP terminal 3401 and the RFIC 3305 on the mobile terminal 3301 are connected with each other.

Also, as a description for signal flow, a signal from the non-contact IC card microcomputer 3104 is sent to the SIM adapter 3302, and then, is sent from the SIM adapter 3302 to the RFIC 3305 on the mobile terminal 3301 through the SWP terminal 3401. Note that the signal from the non-contact IC card microcomputer 3104 may be sent to the SWP terminal 3401 through the SIM secure microcomputer 3107 or not through the SIM secure microcomputer 3107.

### (Twentieth Embodiment)

A twentieth embodiment is a modified example of the nineteenth embodiment.

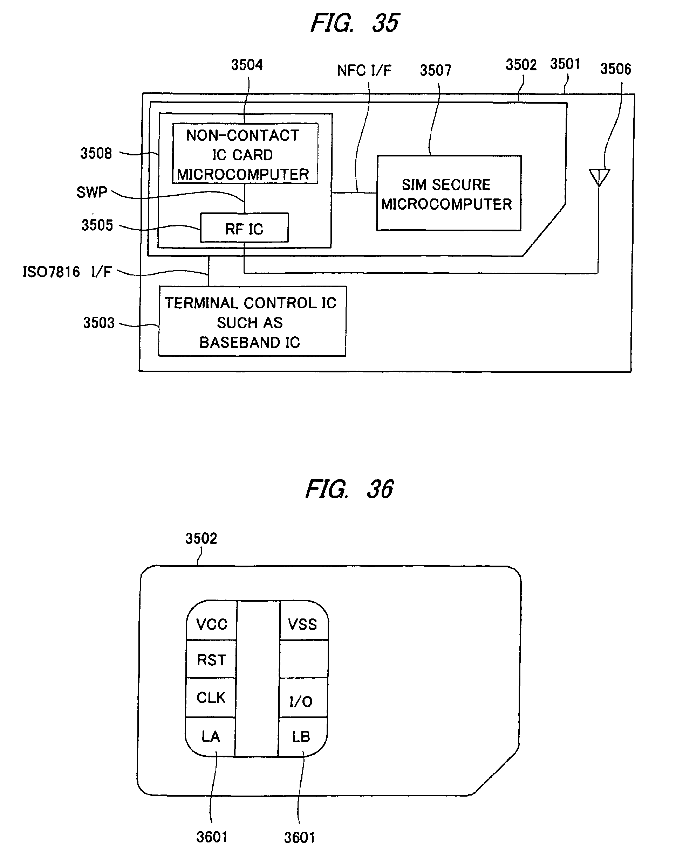

FIG. 35 is a block diagram illustrating a configuration of a mobile terminal according to the twentieth embodiment of the present invention. FIG. 36 is a diagram illustrating an example of a terminal arrangement (ISO7816 terminals and antenna terminal) on a rear surface of a SIM adapter illustrated in FIG. 35.

A mobile terminal 3501 according to the twentieth embodiment includes, for example: a SIM adapter 3502 on which a SIM secure microcomputer 3507 is mounted; a terminal control IC 3503 such as a baseband IC; an antenna 3506; and others. An ISO7816 I/F connects between the SIM adapter 3502 and the terminal control IC 3503 such as a baseband IC. Into the SIM adapter 3502, a micro card 3508 having the NFC functionality on which a non-contact IC card microcomputer 3504 and a RFIC 3505 are mounted is inserted. A SWP connects between the non-contact IC card microcomputer 3504 and the RFIC 3505.

As illustrated in FIG. 35, an expansion card having functionalities of the NFC non-contact IC card microcomputer and the RFIC and the functionality of the Near Field Communication (NFC) used for a non-contact IC card or others is attached in the SIM adapter, so that the functionality expansion is freely achieved without preparing a new expansion socket or others on the terminal side. Also, as illustrated in FIG. 36, in the terminal arrangement on the rear surface of the SIM adapter 3502, an antenna terminal 3601 is provided in an available terminal in the ISO7816 as a functionality-expansion terminal for connecting with the RFIC.

Note that, when the card in which the NFC functionality is installed has the same thickness as that of the SIM adapter or thinner, a top panel may be not used.

Even when the card in which the NFC functionality is installed has a larger thickness than that of the SIM adapter, the top panel may be not used as long as it is not necessarily used.

### (Twenty-first embodiment)

A twenty-first embodiment describes a configuration example of the SIM adapter and the expansion card (micro card having the NFC functionality) described in the nineteenth and twentieth embodiments.

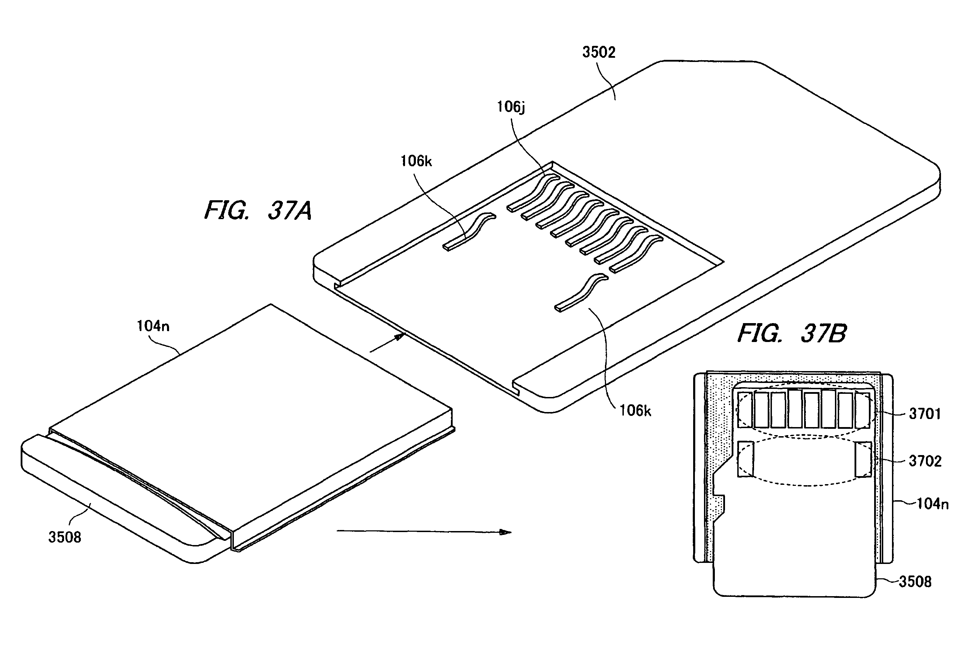

FIGs. 37A and 37B are views illustrating an outline of a SIM adapter according to the twenty-first embodiment of the present invention, FIG. 37A illustrates a state before the expansion card is inserted into the SIM adapter, and FIG. 37B illustrates a state that the expansion card is attached in a top panel, as viewed from a rear surface.

As illustrated in FIG. 37A, on a card slot in a SIM adapter 3502, a terminal strip (terminal) 106j for connecting with the expansion card and an expansion-terminal strip (terminal) 106k for a NFC are arranged. And, a micro card 3508 having the NFC functionality is attached in a top panel 104n as the expansion card, and they are inserted into the SIM adapter 3502.

As illustrated in FIG. 37B, on the micro card 3508 having the NFC functionality, a memory-card terminal (electrode terminal) 3701 contacting with the terminal strips 106j and 106k for electrical connection and a NFC-functionality-expansion terminal (electrode terminal) 3702 are arranged.

As attaching the micro card 3508 having the NFC functionality in the top panel 104n, the micro card and the top panel are inserted into the SIM adapter 3502, so that the NFC-functionality expansion can be achieved in the Plug-in-SIM.

The micro card 3508 may be inserted into the SIM adapter 3502 after the micro card is attached in the top panel 104n, or a top panel for holding the micro card 3508 may be provided on the SIM adapter 3502.

The micro card 3508 to be inserted into the SIM adapter 3502 may be achieved by also mounting a NFC chip on a standard memory card and additionally expanding a necessary terminal for the NFC in the terminal of the memory card, or by forming a card with an original outline and terminal for only the NFC functionality. The micro card, even when the micro card is attached in the SIM adapter, may be achieved to be a down-sized and thinned card having a standard Plug-in SIM size by focusing on the necessary functionalities for the NFC and minimizing the number of terminals.

When the card in which the NFC functionality is installed has the same thickness as that of the SIM adapter or thinner, the top panel may be not used.

Even when the card in which the NFC functionality is installed has a thickness thicker than that of the SIM adapter, the top panel may be not used unless the top panel is required to be used.

Also, although the non-contact IC card microcomputer or others is mounted on the card such as a micro card to be inserted into the SIM adapter in the nineteenth to twenty-first embodiments, it may be mounted on the SIM adapter side due to the thickness of the micro card or others or cost.

In this manner, even when one micro card is not inserted into the SIM adapter, the NFC functionality can be used.

Further, depending on cost or a user's requirement, not the configuration having the SIM adapter and the micro card but a configuration that the NFC functionality or others is installed in a SIM card without an adapter may be used.

In this case, the micro card or others is not required to be inserted into the SIM adapter, and therefore, connections in the card become stable.

Note that each of the first to twenty-first embodiments may be properly combined with the other.

Still further, a part of each embodiment may be extracted and combined with the other.

Still further, with inserting the smaller card than the SIM card into the SIM adapter, the memory-volume expansion and the NFC-functionality expansion have been exemplified.

However, with inserting the smaller card, expansion of other functionality such as calculation functionality or others may be achieved.

That is, with inserting the smaller card into the SIM adapter, a new functionality may be obtained.

In the foregoing, the invention made by the inventors has been concretely described based on the embodiments. However, it is needless to say that the present invention is not limited to the foregoing embodiments and various modifications and alterations can be made within the scope of the present invention.

For example, a plurality of types of top panels are prepared, and outline difference in differently-outlined memory cards from each other is offset by each top panel, so that a plurality of types of memory cards can be attached in a SIM adapter.

### INDUSTRIAL APPLICABILITY

The present invention can be used in manufacturing industry for an IC card, an electric device, or others.

## Claims

1. A SIM adapter having a recess portion to which a memory card is inserted, on which a secure IC chip having a security microcomputer functionality is mounted, comprising:
a top panel for covering the recess portion, wherein,
when the memory card is not inserted, the top panel is positioned at a first height, and,
when the memory card is inserted, a part of the top panel is engaged with a part of the SIM adapter so that the top panel is latched at a second height higher than the first height.

2. The SIM adapter according to claim 1, wherein
the top panel has a convex shape.

3. The SIM adapter according to claim 1, wherein
a protrusion is provided in the recess portion on a side from which the memory card is inserted, and
the top panel is latched by the protrusion.

4. The SIM adapter according to claim 1, wherein
the top panel is made of a metal.

5. The SIM adapter according to claim 4, wherein
at least a part of the top panel is covered by an insulating film.

6. The SIM adapter according to claim 4, wherein
the top panel is electrically connected with a main board GND of the SIM adapter.

7. The SIM adapter according to claim 1, wherein
a terminal strip contacting with a terminal of the memory card for electrical connection is provided on the recess portion,
when the memory card is not inserted, the top panel is pushed up by the terminal strip, and
when the SIM adapter is inserted into a SIM socket, the top panel is pushed down by the SIM socket, so that urging force of the terminal strip works to the top panel.

8. A SIM adapter having a recess portion to which a memory card is inserted, on which a secure IC chip having a security microcomputer functionality is mounted, wherein
a top panel for covering the memory card is inserted when the memory card is inserted, and
a part of the top panel is engaged with a part of the SIM adapter so that the top panel is latched.

9. The SIM adapter according to claim 8, wherein
a hole is opened in the part of the top panel,
a protrusion is provided in the part of the SIM adapter, and the hole and the protrusion are engaged with each other so that the top panel is latched.

10. The SIM adapter according to claim 8, wherein,
when the memory card is not inserted, a plate is inserted into the recess portion instead of the top panel and the memory card, and
the plate has a thickness not forming a convex portion on a surface of the SIM adapter when the plate is inserted.

11. The SIM adapter according to claim 10, wherein
a terminal strip contacting with a terminal of the memory card for electrical connection is provided on the recess portion, and
the plate has a concave portion on a position facing the terminal strip when the plate is inserted.

12. The SIM adapter according to claim 8, wherein
a switch for detecting whether the top panel is inserted or not is provided on the recess portion.

13. The SIM adapter according to claim 8, wherein
the top panel is made of a metal, and
at least a part of the top panel is covered by an insulating film.

14. The SIM adapter according to claim 8, wherein
the top panel has a spring for preventing coming off of the memory card when the memory card is inserted into the top panel.

15. The SIM adapter according to claim 8, wherein
the top panel has an attachment for preventing to drop the memory card when the memory card is inserted into the top panel.

16. The SIM adapter according to claim 8, wherein
a terminal strip contacting with a terminal of the memory card for electrical connection is provided on the recess portion, and
one end of the terminal strip on a side from which the memory card is inserted is adhered on the SIM card.

17. A SIM adapter having a recess portion to which a memory card is inserted, on which a secure IC chip having a security microcomputer functionality is mounted, wherein,
when the memory card is inserted, a top panel for covering the memory card is inserted, and
a terminal strip contacting with both of a terminal of the SIM adapter and a terminal of the memory card for electrical connection when the memory card is inserted is provided on the top panel.

18. A SIM adapter having a recess portion to which a card having a plurality of electrode terminals is inserted, on which a secure IC chip having a security microcomputer functionality is mounted, wherein
a plurality of first terminals each connected with the plurality of electrode terminals of the card are provided on the recess portion, and
the first terminals each has a wireless terminal connected with an electrode terminal connected with a functionality unit for near field communication in the card.

19. The SIM adapter according to claim 18, wherein
The SIM adapter has a second terminal connected with a mobile phone, and
the second terminal has a terminal to be connected with a RFIC in the mobile phone.

20. A SIM card comprising:
a SIM adapter having a recess portion to which a card is inserted, on which a secure IC chip having a security microcomputer functionality is mounted; and
a card having a functionality of near field communication, which is inserted into the recess portion.

21. The SIM card according to claim 20, wherein
the card having the functionality of near field communication has a microcomputer for processing the near field communication.
